# EUROPEAN PATENT SPECIFICATION

(11) **EP 2 382 535 B1**
(45) Date of publication and mention of the grant of the patent: **29.03.2017**
(21) Application number: 10701268.4
(22) Date of filing: 08.01.2010
(51) Int. Cl.: G06F 7/575, H03H 17/06

(54) **SYMMETRIC TRANSPOSE CONVOLUTION FIR FILTER WITH PRE-ADDER**
KONVOLUTIONS-FIR-FILTER DER TRANSPONIERTEN FORM MIT VORADDIERUNGSSTUFE
FILTRE DE CONVOLUTION À RÉPONSE IMPULSIONNELLE FINIE DE FORME TRANSPOSÉE AVEC PRÉ-ADDITIONNEUR

(30) Priority: 27.01.2009 US 360836; 06.04.2009 US 418979
(43) Date of publication of application: 02.11.2011
(73) Proprietor: Xilinx, Inc., San Jose, California 95124 (US)
(72) Inventor: SIMKINS, James, M., San Jose California 95124 (US); CHING, Alvin, Y., San Jose California 95124 (US); THENDEAN, John, M., San Jose California 95124 (US); VADI, Vasisht, M., San Jose CA 95124 (US); POON, Chi Fung, San Jose California 95124 (US); RAB, Muhammad, A., San Jose California 95124 (US); WENDLING, Xavier, San Jose California 95124 (US)
(74) Representative: Naismith, Robert Stewart
(86) International application number: PCT/US2010/020565
(87) International publication number: WO 2010/088017

(56) References cited:
- US-A- 5 165 034
- US-A- 5 241 492
- US-A- 5 258 939
- US-A- 6 065 034
- US-A1- 2006 212 499
- US-B1- 6 731 706
- "sections 26.2-26.5" In: B. Parhami: "COMPUTER ARITHMETIC, Algorithms and Hardware Designs" 2000, Oxford University Press, Inc , New York, NY, USA 239790 , XP002570130 ISBN: 0195125835 , pages 432-443 paragraph [0006] - last paragraph page 434, paragraph 1; figure 26.11
- MASUD S ET AL: "Reusable Silicon IP Cores for Discrete Wavelet Transform Applications" IEEE TRANSACTIONS ON CIRCUITS AND SYSTEMS PART I: REGULAR PAPERS, IEEE SERVICE CENTER, NEW YORK, NY, US LNKD- DOI:10.1109/TCSI.2004.829236, vol. 51, no. 6, 1 June 2004 (2004-06-01), pages 1114-1124, XP011113915 ISSN: 1057-7122
- MAR M F ET AL: "Digital filter design for compact on-chip oversampling A/D conversion" CUSTOM INTEGRATED CIRCUITS CONFERENCE, 1993., PROCEEDINGS OF THE IEEE 1993 SAN DIEGO, CA, USA 9-12 MAY 1993, NEW YORK, NY, USA,IEEE LNKD- DOI:10.1109/CICC.1993.590719, 9 May 1993 (1993-05-09), pages 15.2.1-15.2.4, XP010222127 ISBN: 978-0-7803-0826-8

## Description

### FIELD OF THE INVENTION

The invention relates to integrated circuit devices ("ICs"). More particularly, the invention relates to a digital signal processing block with a preadder stage for an IC.

### BACKGROUND OF THE INVENTION

Programmable logic devices ("PLDs") are a well-known type of integrated circuit that can be programmed to perform specified logic functions. One type of PLD, the field programmable gate array ("FPGA"), typically includes an array of programmable tiles. These programmable tiles can include, for example, input/output blocks ("IOBs"), configurable logic blocks ("CLBs"), dedicated random access memory blocks ("BRAMs"), multipliers, digital signal processing blocks ("DSPs"), processors, clock managers, delay lock loops ("DLLs"), and so forth. As used herein, "include" and "including" mean including without limitation.

Each programmable tile typically includes both programmable interconnect and programmable logic. The programmable interconnect typically includes a large number of interconnect lines of varying lengths interconnected by programmable interconnect points ("PIPs"). The programmable logic implements the logic of a user design using programmable elements that can include, for example, function generators, registers, arithmetic logic, and so forth.

The programmable interconnect and programmable logic are typically programmed by loading a stream of configuration data into internal configuration memory cells that define how the programmable elements are configured. The configuration data can be read from memory (e.g., from an external PROM) or written into the FPGA by an external device. The collective states of the individual memory cells then determine the function of the FPGA.

Another type of PLD is the Complex Programmable Logic Device, or CPLD. A CPLD includes two or more "function blocks" connected together and to input/output ("I/O") resources by an interconnect switch matrix. Each function block of the CPLD includes a two-level AND/OR structure similar to those used in Programmable Logic Arrays ("PLAs") and Programmable Array Logic ("PAL") devices. In CPLDs, configuration data is typically stored on-chip in non-volatile memory. In some CPLDs, configuration data is stored on-chip in non-volatile memory, then downloaded to volatile memory as part of an initial configuration (programming) sequence.

For all of these programmable logic devices ("PLDs"), the functionality of the device is controlled by data bits provided to the device for that purpose. The data bits can be stored in volatile memory (e.g., static memory cells, as in FPGAs and some CPLDs), in non-volatile memory (e.g., FLASH memory, as in some CPLDs), or in any other type of memory cell.

Other PLDs are programmed by applying a processing layer, such as a metal layer, that programmably interconnects the various elements on the device. These PLDs are known as mask programmable devices. PLDs can also be implemented in other ways, e.g., using fuse or antifuse technology. The terms "PLD" and "programmable logic device" include but are not limited to these exemplary devices, as well as encompassing devices that are only partially programmable. For example, one type of PLD includes a combination of hard-coded transistor logic and a programmable switch fabric that programmably interconnects the hard-coded transistor logic.

Performance of a design instantiated in programmable logic of an FPGA ("FPGA fabric") is limited by the speed of the FPGA fabric. However, dedicated circuit resources, such as DSPs in an FPGA, are capable of performing operations faster than equivalent circuits implemented in FPGA fabric. Accordingly, it would be desirable and useful to provide means for expanding the usefulness of DSPs.

Integrated circuits comprise a variety of circuit elements which are used to implement a circuit design. The circuit design must be laid out or "placed" according to the types and available locations of the circuit elements of an integrated circuit. That is, the components of the circuit design must be assigned or placed in sites of an integrated circuit. In placing components of the circuit design, various factors are considered in deciding on the placement. Efficiency in placing components and improving the efficiency of implementing the components may lead to significant improvements in the use of the integrated circuit devices.

While conventional integrated circuits are inefficient when implementing arithmetic operations typical of digital signal processing (DSP) applications, some integrated circuits may employ circuit blocks which are dedicated to implement DSP functions. However, DSP blocks in conventional devices may lead to inherently inefficient layouts or may lead to inefficient usage of circuits needed to implement the DSP application. That is, an integrated circuit having a DSP block which provides limited functions may result in an inefficient use of circuit resources. A DSP block which may improve the efficiency of a circuit layout may result in significant improvements in the use of the integrated circuit.

US Patent 5,258,939, Johnstone et al., describes decimation circuitry having a forward shifting data section. The input data from the first decimation register in the forward shifting data section is shifted through the other decimation registers and is "folded" over to the backward shifting data section at the centre tap. The data samples are added in ALUs prior to the multipliers. The outputs of the multipliers in the FIR are summed and sent to the output section. In case of an odd number of taps, the centre sample is repeated, i.e. comes from both the forward and reverse paths so that the centre coefficient must be scaled in half or only have one value passed by the ALU to the multiplier. The centre coefficient C0 may be scaled in half to be C0/2.

### SUMMARY OF THE INVENTION

Various aspects of the present invention are defined in the independent claims.

Some preferred features are defined in the dependent claims

One or more aspects generally relate to integrated circuit devices ("ICs") and, more particularly, to a symmetric transpose convolution FIR filter of an IC.

One embodiment of the present invention relates generally to a symmetric transpose convolution FIR filter of an IC, comprising:
an input signal;
a first DSP stage to receive the input signal and a first coefficient, wherein the first DSP stage comprises:
   a first pre-adder coupled to receive the input signal at a first register with an associated one cycle delay and a zero input;
   a second register coupled to an output of the first pre-adder;
   a third register coupled to receive the first coefficient;
   a first multiplier coupled to the second register and the third register;
   a fourth register coupled to an output of the first multiplier;
   a fifth register coupled to store an output of the first DSP stage; and
   a first adder coupled to the fourth register and a zero input, wherein an output of the first adder is coupled to the fifth register; and
   a second DSP stage to receive the input signal, a first common coefficient, a first tap associated with the first common coefficient from the first register of the first DSP stage, and the output of the first DSP stage, wherein the second DSP stage comprises:
      a second pre-adder coupled to receive the first tap from the first register of the first DSP stage at a sixth register with an associated two cycle delay and the input signal at a seventh register with an associated one cycle delay, such that inputs are received from the sixth register and the seventh register at the second pre-adder;
      an eighth register coupled to an output of the second pre-adder;
      a ninth register coupled to receive the first common coefficient;
      a second multiplier coupled to the eighth register and the ninth register;
      a tenth register coupled to an output of the second multiplier;
      an eleventh register coupled to store an output of the second DSP stage; and
      a second adder coupled to the tenth register and the output of the first DSP stage, wherein an output of the second adder is coupled to the eleventh register; and
   a third DSP stage to receive the input signal, a second common coefficient, a second tap associated with the second common coefficient from the sixth register of the second DSP stage, and an output of the second DSP stage, wherein the third DSP stage comprises:
      a third pre-adder coupled to receive the second tap from the sixth register of the second DSP stage at a twelfth register with an associated two cycle delay and the input signal at a thirteenth register with an associated one cycle delay, such that inputs are received from the twelfth register and the thirteenth register at the third pre-adder;
      a fourteenth register coupled to an output of the third pre-adder;
      a fifteenth register coupled to receive the second common coefficient;
      a third multiplier coupled to the fourteenth register and the fifteenth register;
      a sixteenth register coupled to an output of the third multiplier;
      a seventeenth register to store an output of the third DSP stage; and
      a third adder, coupled to the sixteenth register, to add an output of the third multiplier to the output of the second DSP stage, wherein an output of the third adder is coupled to the seventeenth register.

A second embodiment of the present invention relates generally to a symmetric transpose convolution FIR filter of an IC, comprising:
an input signal;
a first DSP stage to receive the input signal and a first common coefficient, wherein the first DSP stage comprises:
   a first pre-adder coupled to receive the input signal at a first register with an associated two cycle delay and at a second register with an associated one cycle delay, such that inputs are received from the first register and the second register at the first pre-adder;
   a third register coupled to an output of the first pre-adder;
   a fourth register coupled to receive the first common coefficient;
   a first multiplier coupled to the third register and the fourth register;
   a fifth register coupled to an output of the first multiplier;
   a sixth register coupled to store an output of the first DSP stage; and
   a first adder coupled to the fifth register and a zero input, wherein an output of the first adder is coupled to the sixth register; and
   a second DSP stage to receive the input signal, a second common coefficient, a first tap associated with the second common coefficient from the first register of the first DSP stage, and an output of the first DSP stage, wherein the second DSP stage comprises:
      a second pre-adder coupled to receive the first tap from the first register of the first DSP stage at a seventh register with an associated two cycle delay and the input signal at an eighth register with an associated one cycle delay, such that inputs are received from the sixth register and the seventh register at the second pre-adder;
      a ninth register coupled to an output of the second pre-adder;
      a tenth register coupled to receive the second common coefficient;
      a second multiplier coupled to the ninth register and the tenth register;
      an eleventh register coupled to an output of the second multiplier;
      a twelfth register to store an output of the second DSP stage; and
      a second adder coupled to the eleventh register and the output of the first DSP stage, wherein an output of the second adder is coupled to the twelfth register; and
   a third DSP stage to receive the input signal, a third common coefficient, a second tap associated with the third common coefficient from the seventh register of the second DSP stage, and an output of the second DSP stage, wherein the third DSP stage comprises:
      a third pre-adder coupled to the second tap from the seventh register of the second DSP stage at a thirteenth register with an associated two cycle delay and the input signal at a fourteenth register with an associated one cycle delay, such that inputs are received from the twelfth register and the thirteenth register at the third pre-adder;
      a fifteenth register coupled to an output of the third pre-adder;
      a sixteenth register coupled to receive the third common coefficient;
      a third multiplier coupled to the fifteenth register and the sixteenth register;
      a seventeenth register coupled to an output of the third multiplier;
      an eighteenth register to store an output of the third DSP stage; and
      a third adder, coupled to the seventeenth register, to add an output of the third multiplier to the output of the second DSP stage, wherein an output of the third adder is coupled to the eighteenth register.

A third embodiment of the present invention relates generally to a symmetric transpose convolution FIR filter of an IC, comprising:
an input signal;
a first DSP stage to receive the input signal and a first common coefficient (k₂/2), wherein the first DSP stage comprises:
   a first pre-adder coupled to receive the input signal at a first register with an associated one cycle delay and at a second register with an associated one cycle delay, such that the same inputs are received from the first register and the second register at the first pre-adder;
   a third register coupled to an output of the first pre-adder;
   a fourth register coupled to receive the first common coefficient;
   a first multiplier coupled to the third register and the fourth register;
   a fifth register coupled to an output of the first multiplier;
   a sixth register coupled to store an output of the first DSP stage; and
   a first adder coupled to the fifth register and a zero input, wherein an output of the first adder is coupled to the sixth register; and
a second DSP stage to receive the input signal, a second common coefficient, a first tap associated with the second common coefficient from the first register of the first DSP stage, and an output of the first DSP stage, wherein the second DSP stage comprises:
   a second pre-adder coupled to receive the first tap from the first register of the first DSP stage at a seventh register with an associated two cycle delay and the input signal at an eighth register with an associated one cycle delay, such that inputs are received from the sixth register and the seventh register at the second pre-adder;
   a ninth register coupled to an output of the second pre-adder;
   a tenth register coupled to receive the second common coefficient;
   a second multiplier coupled to the ninth register and the tenth register;
   an eleventh register coupled to an output of the second multiplier;
   a twelfth register to store an output of the second DSP stage; and
   a second adder coupled to the eleventh register and the output of the first DSP stage, wherein an output of the second adder is coupled to the twelfth register; and
a third DSP stage to receive the input signal, a third common coefficient, a second tap associated with the third common coefficient from the seventh register of the second DSP stage, and an output of the second DSP stage, wherein the third DSP stage comprises:
   a third pre-adder coupled to the second tap from the seventh register of the second DSP stage at a thirteenth register with an associated two cycle delay and the input signal at a fourteenth register with an associated one cycle delay, such that inputs are received from the twelfth register and the thirteenth register at the third pre-adder;
   a fifteenth register coupled to an output of the third pre-adder;
   a sixteenth register coupled to receive the third common coefficient;
   a third multiplier coupled to the fifteenth register and the sixteenth register;
   a seventeenth register coupled to an output of the third multiplier;
   an eighteenth register to store an output of the third DSP stage; and a third adder, coupled to the seventeenth register, to add an output of the third multiplier to the output of the second DSP stage, wherein an output of the third adder is coupled to the eighteenth register.

In each of the three embodiments, the preadder stage can be configured for dynamically setting a first data input of the adder/subtractor to receive a value of zero via output of the first logic gate responsive to input to the second input port. The preadder stage can be configured for dynamically setting a second data input of the adder/subtractor to receive the value of zero via output of the second logic gate responsive to input to the third input port. The preadder stage can be configured for dynamically selecting input data having either a 0-, 1 -, or 2-register delay responsive to input to the first input port. The preadder stage can be configured for dynamically setting the adder/subtractor for either adding or subtracting responsive to input to the fourth input port. This embodiment of the integrated circuit further comprises field programmable logic gates that can be configured responsive to a configuration bitstream to provide an instantiated circuit function for providing input data to the digital signal processing block.

In each of the three embodiments, the preadder stage can be dynamically reconfigurable via at least one port of a group consisting of the first input port, the second input port, the third input port, and the fourth input port without having to reconfigure the field programmable logic gates for providing the input data; and the preadder stage can be dynamically reconfigurable to provide an absolute value function, a sequential complex conjugate function, a sequential multiplication function, a sequential complex multiplication, an multiplexing function, a register file function, a shift-register logic function, and a pipeline rebalancing function.

According to an embodiment of the invention, a method of configuring a filter in a circuit to be implemented in an integrated circuit is disclosed. The method comprises receiving a high level design of the circuit; identifying a filter in the high level design; analyzing coefficients of the filter; and transforming the filter of the high level design to a filter using a processing block of the circuit configured to accommodate a common coefficient, wherein the processing block is coupled to receive taps associated with the common coefficient.

### BRIEF DESCRIPTION OF THE DRAWINGS

Accompanying drawing(s) show exemplary embodiment(s) in accordance with one or more aspects of the invention or examples that are helpful in understanding the present invention; however, the accompanying drawing(s) should not be taken to limit the invention to the embodiment(s) shown, but are for explanation and understanding only.
FIG. 1 is a simplified block diagram depicting an exemplary embodiment of a columnar Field Programmable Gate Array ("FPGA") architecture in which one or more aspects of the invention may be implemented.
FIG. 2 is a block/circuit diagram depicting an exemplary embodiment of a DSP slice.
FIG. 3 is a circuit diagram depicting an exemplary embodiment of a preadder of the DSP slice of FIG. 2.
FIG. 4 is a circuit diagram depicting an exemplary embodiment of a dual B register of the DSP slice of FIG. 2.
FIG. 5 is a table diagram depicting an exemplary embodiment of an inmode function table.
FIG. 6 is a block/circuit diagram depicting an exemplary example of an 8-tap even symmetric systolic finite impulse response ("FIR") filter of the prior art.
FIG. 7 is a block/circuit diagram depicting an exemplary example of an 8-tap even symmetric systolic FIR filter.
FIG. 8 is a block/circuit diagram depicting an exemplary example of a DSP slice of FIG. 7 with an OPMODE of 0,0,1 ,0,1 ,0,1 for implementing a symmetric systolic add-multiply-add processing module.
FIG. 9 is a block/circuit diagram depicting an exemplary example of a 9-tap odd symmetric systolic FIR filter.
FIG. 10 is a block/circuit diagram depicting an alternative exemplary example of a 9-tap odd symmetric systolic FIR filter.
FIG. 11 is a flow diagram depicting an exemplary example of an FIR use flow.
Fig. 12 is a block diagram of a circuit implementing a symmetric transpose convolution finite impulse response filter according to an embodiment of the present invention.
Fig. 13 is a block diagram of a circuit implementing a symmetric transpose convolution finite impulse response filter according to an alternate embodiment of the present invention.
Fig. 14 is a block diagram of a circuit implementing a symmetric transpose convolution finite impulse response filter according to an alternate embodiment of the present invention.
Fig. 15 is a flow chart showing a method of implementing a filter in an integrated circuit according to an example of the present invention.
Fig. 16 is a block diagram of a system for implementing a device having programmable logic according to an embodiment of the present invention.
Fig. 17 is a block diagram of a device having programmable logic according to an embodiment of the present invention.
Fig. 18 is a block diagram of a configurable logic element of a configurable logic block according to an embodiment of the present invention.

### DETAILED DESCRIPTION OF THE DRAWINGS

In the following description, numerous specific details are set forth to provide a more thorough description of the specific embodiments of the invention and examples that are helpful in understanding the present invention. It should be apparent, however, to one skilled in the art, that the invention may be practiced without all the specific details given below. In other instances, well known features have not been described in detail so as not to obscure the invention. For ease of illustration, the same number labels are used in different diagrams to refer to the same items; however, in alternative embodiments and examples the items may be different.

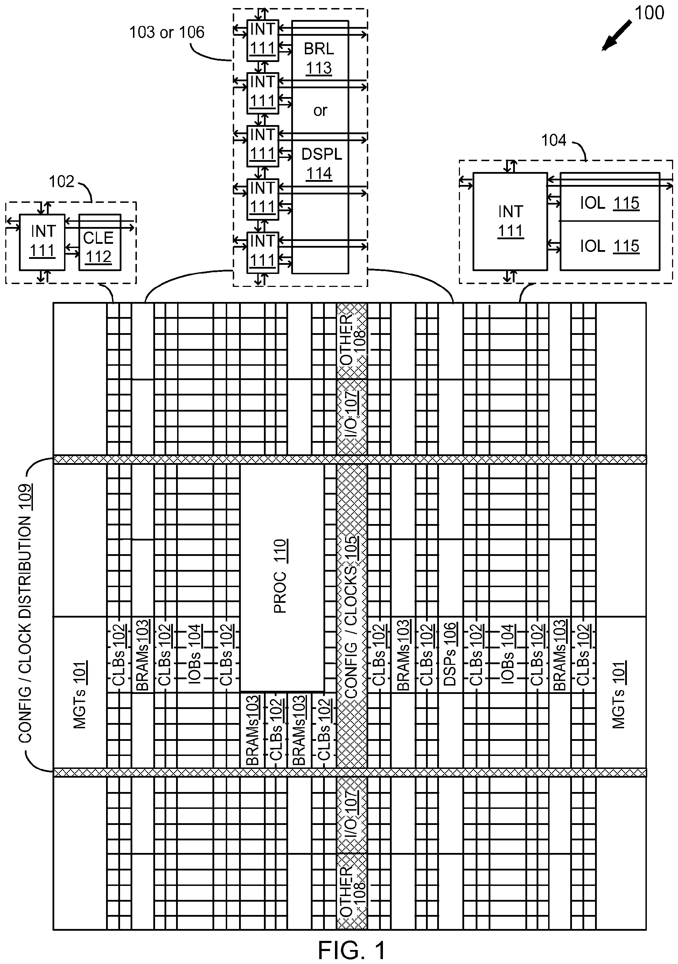

As noted above, advanced FPGAs can include several different types of programmable logic blocks in the array. For example, FIG. 1 illustrates an FPGA architecture 100 that includes a large number of different programmable tiles including multi-gigabit transceivers ("MGTs") 101 , configurable logic blocks ("CLBs") 102, random access memory blocks ("BRAMs") 103, input/output blocks ("IOBs") 104, configuration and clocking logic ("CONFIG/CLOCKS") 105, digital signal processing blocks ("DSPs") 106, specialized input/output blocks ("I/O") 107 (e.g., configuration ports and clock ports), and other programmable logic 108 such as digital clock managers, analog-to-digital converters, system monitoring logic, and so forth. Some FPGAs also include dedicated processor blocks ("PROC") 110.

In some FPGAs, each programmable tile includes a programmable interconnect element ("INT") 111 having standardized connections to and from a corresponding interconnect element in each adjacent tile. Therefore, the programmable interconnect elements taken together implement the programmable interconnect structure for the illustrated FPGA. The programmable interconnect element 111 also includes the connections to and from the programmable logic element within the same tile, as shown by the examples included at the top of FIG. 1.

For example, a CLB 102 can include a configurable logic element ("CLE") 112 that can be programmed to implement user logic plus a single programmable interconnect element ("INT") 111. A BRAM 103 can include a BRAM logic element ("BRL") 113 in addition to one or more programmable interconnect elements. Typically, the number of interconnect elements included in a tile depends on the height of the tile. In the pictured embodiment, a BRAM tile has the same height as five CLBs, but other numbers (e.g., four) can also be used. A DSP tile 106 can include a DSP logic element ("DSPL") 114 in addition to an appropriate number of programmable interconnect elements. An IOB 104 can include, for example, two instances of an input/output logic element ("IOL") 115 in addition to one instance of the programmable interconnect element 111. As will be clear to those of skill in the art, the actual I/O pads connected, for example, to the I/O logic element 115 typically are not confined to the area of the input/output logic element 115.

In the pictured embodiment, a columnar area near the center of the die (shown in FIG. 1) is used for configuration, clock, and other control logic. Horizontal areas 109 extending from this column are used to distribute the clocks and configuration signals across the breadth of the FPGA.

Some FPGAs utilizing the architecture illustrated in FIG. 1 include additional logic blocks that disrupt the regular columnar structure making up a large part of the FPGA. The additional logic blocks can be programmable blocks and/or dedicated logic. For example, processor block 110 spans several columns of CLBs and BRAMs.

Note that FIG. 1 is intended to illustrate only an exemplary FPGA architecture. For example, the numbers of logic blocks in a column, the relative width of the columns, the number and order of columns, the types of logic blocks included in the columns, the relative sizes of the logic blocks, and the interconnect/logic implementations included at the top of FIG. 1 are purely exemplary. For example, in an actual FPGA more than one adjacent column of CLBs is typically included wherever the CLBs appear, to facilitate the efficient implementation of user logic, but the number of adjacent CLB columns varies with the overall size of the FPGA.

DSPs 106 are described in additional detail in U.S. Patent No. 7,472,155 entitled "Integrated Circuit with Cascading DSP Slices" by James M. Simkins, et al. Example implementations of DSPs 106 may be found in Virtex™ and Spartan™ FPGAs available from Xilinx, Inc., of San Jose, California.

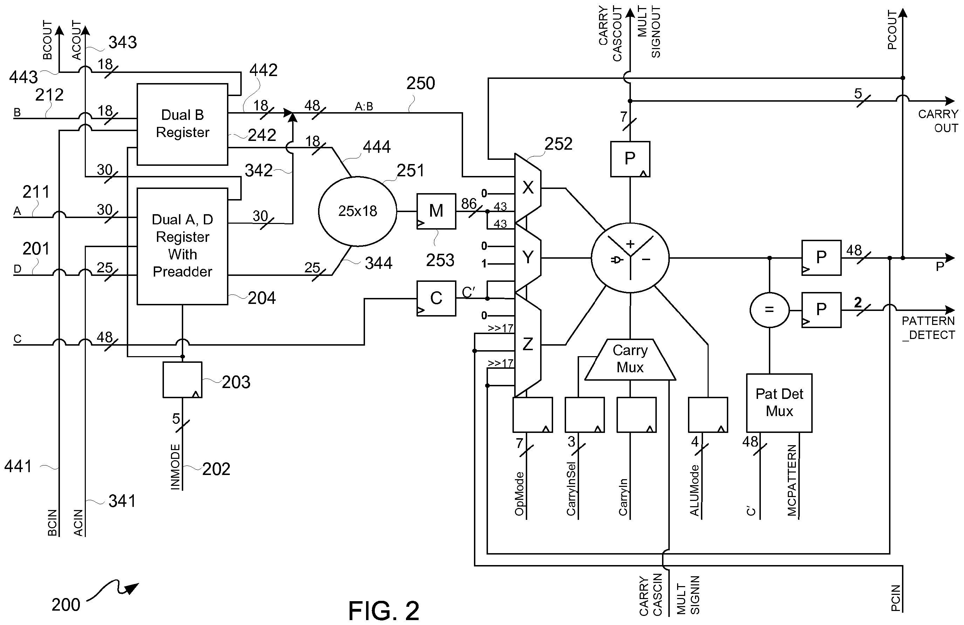

FIG. 2 is a block/circuit diagram depicting an exemplary embodiment of a DSP slice 200. DSP slice 200 may, though need not, be an exemplary embodiment of a DSP 106 of FPGA 100 of FIG. 1. D input signal ("input") 201, A input 211, AC input ("ACIN") 341, and input mode signal ("inmode") 202, are provided to a dual A, D register with preadder ("preadder") 204, where inmode 202 is provided to inmode register 203 for preadder 204. B input 212 and BC input ("BCIN") 441 are provided to dual B register 242. Multiplier 251 and M register 253, as well as a C register and other circuitry to the right thereof in FIG. 2, of DSP slice 200 are conventional, and may be found in Virtex-5™ FPGAs. Accordingly, description of such previously known circuitry is avoided for purposes of clarity. Furthermore, the terms "input" and "output" are used to indicate either or both of a signal and a port, including without limitation their plural forms.

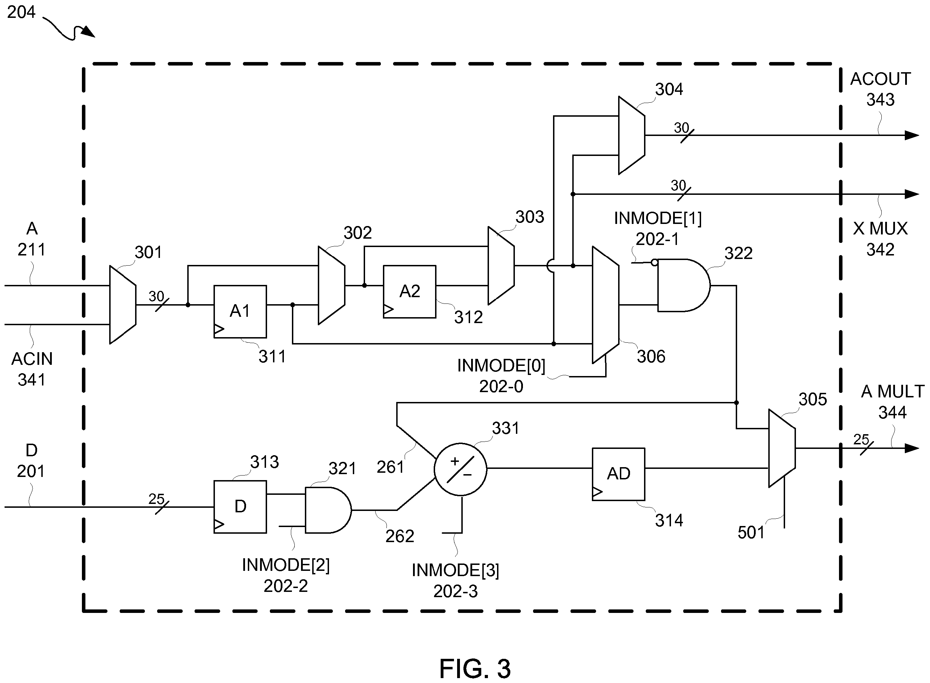

FIG. 3 is a circuit diagram depicting an exemplary embodiment of preadder 204. As described below in additional detail, preadder 204 may be dynamically configured to operate as being 0, 1, 2, or 3 registers deep.

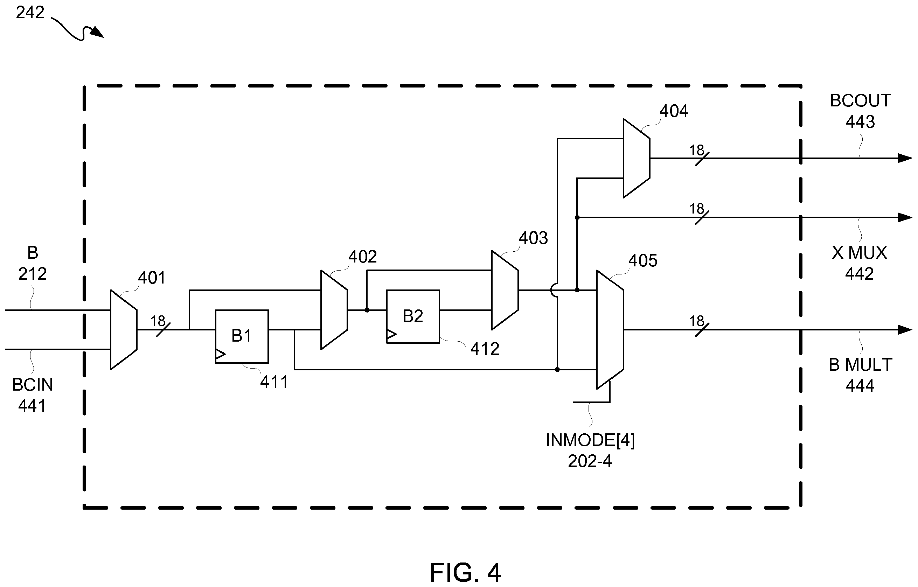

Preadder 204 includes multiplexers 301 through 306, registers 311 through 314, logic gates 321 and 322, and adder/subtractor 331. It should be appreciated that even though bit widths are illustratively shown in FIG. 3, as well as in FIGS. 2 and 4, in accordance with bit widths of a DSP slice of a Virtex-5™ FPGA, bit widths other than, or the same as, those illustratively shown herein, or a combination thereof, may be used.

While not shown for purposes of clarity and not limitation, in this embodiment, control select inputs to multiplexers 301 through 305 are provided from configuration memory cells of FPGA fabric. Such configuration memory cells are configured from a configuration bitstream. Thus, in the context of an FPGA, when such FPGA is obtaining state information as part of a power up cycle, the program states of those memory cells determine selected outputs for multiplexers 301 through 305, and such memory cells are not capable of having their state changed without resetting the FPGA. In other words, the status of multiplexers 301 through 305 during operation is static. In contrast to the static status of multiplexers 301 through 305 during FPGA operation, multiplexer 306 is dynamically operable; in other words, multiplexer 306 may have its control select changed during operation of an FPGA without having to reset such FPGA. Such control select, in this exemplary embodiment, is provided by a portion of inmode 202, namely inmode 202-0, where the "-0" is used to indicate bit position zero of an inmode bus.

Moreover, in addition to dynamic operation of multiplexer 306, logic gates 321 and 322, as well as subtractor 331, may be dynamically operated. Thus, such dynamically operable components may be changed during operation of user design. In this embodiment, inmodes 202-0 through 202-3 of FIG. 3, as well as inmode 202-4 of FIG. 4, may be changed on each cycle of a clock signal. For purposes of clarity by way of example and not limitation, clock signaling such as may be used herein is not shown.

Inmode 202-0 is provided as a dynamic control select signal to multiplexer 306 for gating to provide either A input 211 or AC input 341 as delayed by either of A1 register 311 or A2 register 312, by both A1 register 311 and A2 register 312, or by neither A1 register 311 nor A2 register 312. Again, once selected by memory cell state, a selected output from multiplexers 301 through 305 is static during operation without resetting an FPGA.

Either A input 211 or AC input 341 may be output from multiplexer 301. Output from multiplexer 301 is provided as data input to A1 register 311 and as data input to multiplexer 302. Output of A1 register 311 is provided as data input to multiplexers 302, 304, and 306. Output of multiplexer 302 is provided as data input to A2 register 312 and as data input to multiplexer 303. Output of multiplexer 303 is provided as data input to multiplexers 304 and 306, as well as being provided as an X MUX output 342. Referring to FIG. 2, X MUX output 342 of preadder 204 may be combined with output 442 of dual B register 242 of FIG. 2 for an AB concatenated signal 250.

Returning to FIG. 3, for purposes of clarity by way of example and not limitation, assuming a user has set multiplexers 302 and 303 to select their bottom inputs as outputs, and assuming that a user has selected AC input 341, namely A cascaded input from another DSP slice, as an output of multiplexer 301, then AC input 341 provided as data input to multiplexer 306 is registered by both A1 register 311 and A2 register 312 on an upper data input of multiplexer 306, and on a lower input of multiplexer 306, AC input 341 is registered by just A1 register 311. Accordingly, it should be appreciated that a user may select the register depth to an upper port of multiplexer 306, while the register depth of input to a lower port of multiplexer 306 is always just A1 deep.

As previously mentioned, preadder 204 includes a dual A register and a dual D register. This means, e.g., that A1 register 311 and A2 register 312 are dual-register configurable, even though both A1 and A2 registers, only one of A1 and A2 registers, or neither of A1 and A2 registers may be used in providing input to logic gate 322 via output of multiplexer 306. Furthermore, the dual D register is in reference to D register 313 and AD register 314.

Again, it should be appreciated that the upper input to multiplexer 306, as well as the lower input to multiplexer 304, sourced from the output of multiplexer 301 may be no registers deep, either A1 or A2 deep, or A1 and A2 deep. Furthermore, again, the lower input of multiplexer 306, as well as the upper input of multiplexer 304, is always A1 deep. Output of multiplexer 304 is AC output ("ACOUT") signal ("AC output") 343 of FIG. 2, which may be provided to another DSP slice, similarly to AC input 341 being provided to DSP slice 200 of FIG. 2.

Whether an upper input or a lower input of multiplexer 306 is selected for output is controlled by state of inmode 202-0, and output from multiplexer 306 is provided as data input to logic gate 322. Even though AND gates are illustratively depicted for logic gates 321 and 322, it should be appreciated that other logic gates may be used in accordance with the description herein. The other input of AND gate 322, which is an inverted input, is coupled to receive inmode 202-1. For this embodiment, inmode 202-1 represents bit position one of a bus of inmode 202. Output of AND gate 322 is provided as an input to adder/subtractor 331, namely A path input 261 as described below in additional detail, and to an upper input of multiplexer 305.

D input 201 is provided as data input to D register 313. Data output of D register 313 is provided to an upper input of AND gate 321. A lower input of AND gate 321 is coupled to receive inmode 202-2, which for this embodiment is bit position two of a bus of inmode 202. Output of AND gate 321 is provided as another input to adder/subtractor 331, namely D path input 262 as described below in additional detail. Whether adder/subtractor 331 is configured for adding or subtracting is controlled by inmode 202-3, which for this embodiment is bit position three of a bus of inmode 202. Output of adder/subtractor 331 is provided to a data input port of AD register 314. Output of AD register 314 is provided as another input to multiplexer 305. Output of multiplexer 305 is a multiplier operand signal, namely A multiplier ("A MULT") signal 344 (illustratively shown in FIG. 2).

Again, it should be appreciated that multiplexer 306, AND gate 322, AND gate 321, adder/subtractor 331 are respectively controlled for purposes of dynamic operation by inmodes 202-0 through 202-3, respectively representing bit positions zero through three of a bus of inmode 202. While inmodes 202-0 and 202-3 are used as control select signals for either selecting an output or a function, inmodes 202-1 and 202-2 are operative by their state for affecting or not affecting the output of AND gates 322 and 321, respectively.

In addition to being able to dynamically control AND gates 321 and 322, output of either of AND gates 321 and 322 may be used to source a zero input to adder/subtractor 331. Accordingly, it should be appreciated that if AND gate 322 provides a zero operand input to adder/subtractor 331, then the input of D input 201 which may be provided as an output of multiplexer 305, may pass through registers 313 and 314, namely a two deep register path. Alternatively, if a zero is sourced from the output of AND gate 321, and adder/subtractor 331 is used, then it is possible to have a three deep register path for either of A input 211 or AC input 341, namely through A1 register 311, A2 register 312, and AD register 314.

FIG. 4 is a circuit diagram depicting an exemplary embodiment of dual B register 242 of DSP slice 200 of FIG. 2. B input signal ("B input") 212 and BC input ("BCIN") signal ("BC input") 441 are provided as inputs to multiplexer 401. Multiplexers 401 through 404 of dual B register 242, like multiplexers 301 through 304, are static during operation, namely their outputs are established during configuration of an FPGA and are not dynamically reconfigurable during operation. Multiplexer 405, like multiplexer 306, is dynamically operable responsive to inmode 202-4, which for this embodiment represents bit position four of a bus of inmode 202. B1 register 411 and B2 register 412 correspond to A1 register 311 and A2 register 312. Likewise, multiplexers 401 through 404 respectively correspond to multiplexers 301 through 304. Furthermore, multiplexer 405 corresponds to multiplexer 306. BC output ("BCOUT") signal ("BC output") 443 (illustratively shown in FIG. 2) from multiplexer 404 corresponds to AC output 343, though for this embodiment with a smaller bit width.

Likewise, X multiplexer ("X MUX") signal 442 corresponds to X multiplexer signal 342, though again with a smaller bit width for this embodiment. It should be appreciated that X multiplexer signals 342 and 442 are AB concatenated as generally indicated as AB signal 250 of FIG. 2 for input to an X multiplexer 252.

Output of multiplexer 405 is another multiplier operand signal, namely B multiplier ("B MULT") signal 444 (illustratively shown in FIG. 2), which corresponds to A multiplier signal 344. B multiplier signal 444 and A multiplier signal 344 for this embodiment have different bit widths; however, both outputs may be provided as input operands to a multiplier 251 of FIG. 2. Because dual B register 242 is same or similar to a dual A register portion of preadder 204, repeated description is avoided for purposes of clarity.

With simultaneous reference to FIGS. 2 through 4, DSP slice 200 is further described. Inmode 202 may be considered a dynamic control bus. In addition to inmode 202, there may be a clock signal, a clock enable signal, a set signal, or a reset signal, among other register control signals. These signals are not shown as going into registers for purposes of clarity and not limitation.

AB concatenated signal 250 does not have M register 253 in its path. Thus, a multiply operation between A and B has three pipeline register stages, and an add operation, such as an addition of AB concatenated ("A:B") and C has two register stages. However, by the use of A2 register 312 and B2 register 412, registers A2 312 and B2 412 may be used to provide a register pipeline stage which would otherwise be associated with M register 253. In other words, the number of pipeline stages for inputs to X multiplexer 252 may be configured to be the same within DSP slice 200, which can be used to avoid register misses, namely "bubbles." Accordingly, by setting an operational mode, as described below in additional detail, an A:B + C operation for example and an A*B+C operation for example may both be performed in three clock cycles, e.g., A1 register 311 to A2 register 312 to a P register of FIG. 2 for an A:B + C operation, and A1 register 311 to M register 253 to a P register of FIG. 2 for A of an A*B+C operation (e.g., likewise B1 register 411 to M register 253 to a P register of FIG. 2). A C register of FIG. 2 has one less register than A and B in both of the above examples, but such difference is predictable for all operational modes and thus may be accounted for in FPGA fabric to add in another register stage for C. It should be understood that this allows for dynamically alternating between multiply and add operation on alternate clock cycles without a bubble.

A1 register 311, and A2 register 312, as well as B1 register 411 and B2 register 412, may be used to provide a register file function. Because of the dynamic control bus function of inmode 202, such register file may operate as a random access register file. Alternatively, A1 register 311, and A2 register 312, as well as B1 register 411 and B2 register 412, may be configured to provide shift register logic ("SRL"). Thus dual functionality of both a random access register file and an SRL is provided within DSP slice 200 using dynamic control via an inmode bus 202. Bus, e.g., can mean either a group of signals or a group of signal traces, or both.

Other functionality includes having preadder 204 used as a two-to-one multiplexer, namely by having adder/subtractor 331 select between inputs thereto for output to AD register 314 by having one of the operands be zero. In other words, one of outputs of AND gates 322 and 321 may be respectively forced to zero respectively, responsive to inmode 202-1 and 202-2. Additionally, if output of the A input path is a negative, then a zero may be sourced from the operand input along the D path to adder/subtractor 331 such that adder/subtractor 331 may be used to produce an absolute value of an A or AC operand provided to adder/subtractor 331. Furthermore, by shifting bits using A1 and A2 registers, a twos complement inversion may be performed.

Thus, to recapitulate, inmode 202-0 is used as a none/A1/A2 select signal. Inmode 202-1 may be used to zero output along an A register path, namely registers A1 and A2 ("A registers"). In other words, the ability to zero output facilitates multiplexing between A registers and a D register without using resets and without destroying register contents. When inmode 202-1 is equal to a logic 1, A path input 261 to adder/subtractor 331 is forced to zero, and thus D path input 262 to preadder 331 may be effectively selected for output. Additionally, when inmode 202-1 is equal to logic 1, A path input 261 to multiplexer 305 may be used to force A multiplier signal 344 to zero. However, in order to force A multiplier signal 344 to zero, the D port setting, namely the configuration memory cell setting for providing a control select signal to multiplexer 305 is set for disabling the D port, namely "if use_D port = false."

Inmode 202-2 may be used to zero output of D register 313 along the lines previously described with respect to inmode 202-1 and output of an A register selected path. Thus, D path input 262 to adder/subtractor 331 would be a logic 0, which may be used for facilitating multiplexing between A path input 261 and D path input 262. Furthermore, inmode 202-1 and inmode 202-2 may be used for dynamic power gating for power conservation. If inmode 202-1 is at a logic 1 state, the A path input 261 to adder/subtractor 331 is forced to 0, and if inmode 202-2 is at a logic 0 state, the D path input 262 to adder/subtractor 331 is forced to 0. If both inputs to adder/subtractor 331 are logic 0, operation of adder/subtractor 331 consumes less power as there is no transistor switching within adder/subtractor 331 under such condition. Thus, by "dynamic power gating," it is meant that both inputs to adder/subtractor 331 may be set to logic zero when adder/subtractor 331 functionality is not selected. By having fixed logic values provided as operand inputs to adder/subtractor 331, adder/subtractor 331 does not switch, and this may be used for dynamic conservation of power. In other words, because inmodes may be dynamically set for dynamically fixing operand inputs to adder/subtractor 331, adder/subtractor functionality may be dynamically selected or deselected, and with respect to the later, dynamic power conservation may be implemented.

Inmode 202-3 may be used to have the A operand of A input path 261 either added to or subtracted from the D operand of D input path 262 by adder/subtractor 331. Again, dynamic inversion of an A operand on A input path 261 may be used as an absolute value function. In other words, a register value held in A1 or A2 for example may be dynamically inverted by having the D operand input 262 forced to zero as previously described.

Inmode 202-4 may be used as a B1/B2 register select signal in the same way that inmode 202-0 may be used as an A1/A2 register select signal. Accordingly, it should be appreciated that functionality of DSP slice 200 extends well beyond simply adding a preadder to a DSP as was done in the Spartan™ FPGA DSP 48A available from Xilinx, Inc., of San Jose, California.

Furthermore, it should be appreciated that complex multiplication operations may be performed, such as (A+ai)*(B+bi)=(AB-ab)+(Ab+aB)i. A and a may be separate operands respectively input to A2 register 312 and A1 register 311 by using separate clock enable signals provided to those registers, and selectively outputting one of such two operands from multiplexer 306 responsive to inmode 202-0. Likewise, B and b may be separate operands respectively input to B2 register 412 and B1 register 411 by using separate clock enable signals provided to those registers, and selectively outputting one of such two operands from multiplexer 405 responsive to inmode 202-4. Operands A, B, a, and b may be stored locally in BRAM. Because of operand reuse, BRAM is only accessed in bursts of every other two clock cycles by DSP slice 200, may be read only once for the example complex multiplication operation, as A1, A2, B1 and B2 registers may be used to locally store the real and imaginary parts of such operands. Even though the example of a complex multiplication was used, it should be understood that the same may be said for performing a sequential multiplication, such as (A:a)*(B:b) for example. For purposes of clarity by way of example and not limitation, suppose 42 bits * 34 bits is for (A:a)*(B:b), then the result may be obtained by A*B + sh17(A*0b + B*00000000a +sh17(0b*00000000a), where "sh17" indicates a 17 bit shift.

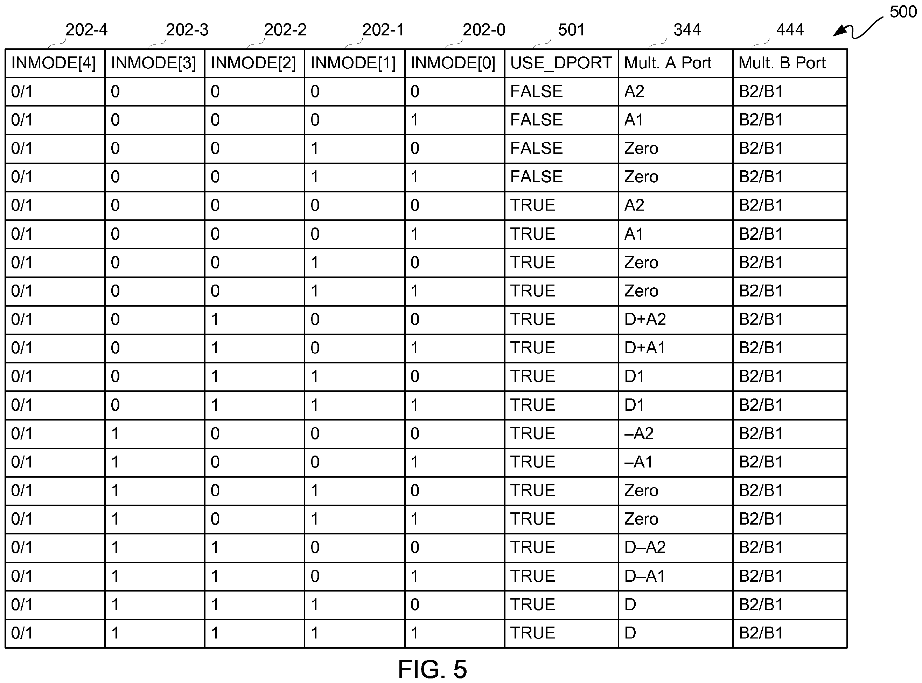

FIG. 5 is a table diagram depicting an exemplary embodiment of an inmode function table 500. The first five columns of table 500 respectively show possible logic states of inmode bits four through zero respectively corresponding to inmodes 202-4 through 202-0. Inmode 202-4 is a B2/B1 register select signal, and thus if a logic 0 is the state of inmode 202-4 contents of register B2 may be provided as multiplier B port 444 input, and if inmode 202-4 is a logic state 1, multiplier B port 444 input is the contents of B1 register 411. Accordingly, logic 0 and 1 of the first column of table 500 respectively correspond to B2 and B1 of the last column of table 500.

The sixth column of table 500 indicates programming state of a memory cell used to provide control select control of multiplexer 305 of FIG. 3, which is generally indicated as control select signal 501 (illustratively shown in FIG. 3). Thus, control select signal 501 indicates whether the D port, namely D input 201, is in use. As indicated in the first four rows of table 500, a false value indicates that the D port of preadder 204 is not in use. The remaining rows in column 501 indicate a true value for control signal 501 meaning that the D port of preadder 204 is in use.

The seventh column of table 500 indicates the operand input on multiplier A port 344. The possible operand inputs illustratively shown are the values held in A1 or A2 for D registers. Additionally, as previously described, a logic 0 may be provided as A multiplier output 344. Furthermore, the value obtained by adding the operand values of D + A2, D + A1, D - A2, or D - A1, as stored in AD register 314 may be provided as A multiplier output 344. The notation A1/A2 and B1/B2 is used to describe one- and two-deep registers, respectively. If A input operands to adder/subtractor 331 are gated off, then registers D 313 and AD 314 in combination appear like a two-deep registration for D port 201. Thus, the notation D1/D2 respectively refers to D/AD registers for one- and two-deep registration, respectively.

In the Spartan™ FPGA the preadder is positioned between an input register and an output register, where the output register feeds the multiplier. However, this configuration cannot be used for implementing a systolic filter. In the following description, DSP slices 200 are described for implementing a systolic filter.

It should be understood that DSP slice 200 with the addition of preadder 204 and dual B register 242 is capable of supporting sequential complex multiplications, sequential multiplications, and sequential complex conjugate operations. Additionally, the ability to balance the AB concatenation path with the AB multiply path by having A2 and B2 registers essentially be virtual registers with respect to M register 253 allows dynamic switching between multiply and add operations with a three stage pipeline. Furthermore, the ability to dynamically access A1 , A2, B1 , B2, registers for writing to either of two deep input registers or reading from either of two deep input registers is facilitated by inmode 202, as previously described. Moreover, the flexibility to have zero input to either preadder input port facilitates a multichannel filters.

Three sets of filter coefficients may be locally stored, such as using A1 register 311 , A2 register 312, and D register 313 and being able to switch from symmetric to non-symmetric operations dynamically, namely on each clock cycle. Additionally, it should be appreciated that the AD multiplexing capability of using adder/subtractor 331 , when add and subtraction functionality is not needed, is supported for dynamic operations. When three sets of filter coefficient are stored locally, then preadder symmetry is not being used. Raw data is being applied via B input port 212 and/or B cascade input port 441 instead of A input port 211 and/or A cascade input port 341 , and filter coefficients may be selected by using adder/subtractor 331 to provide a multiplexing function. Thus non-symmetric filters are possible with three sets of filter coefficients.

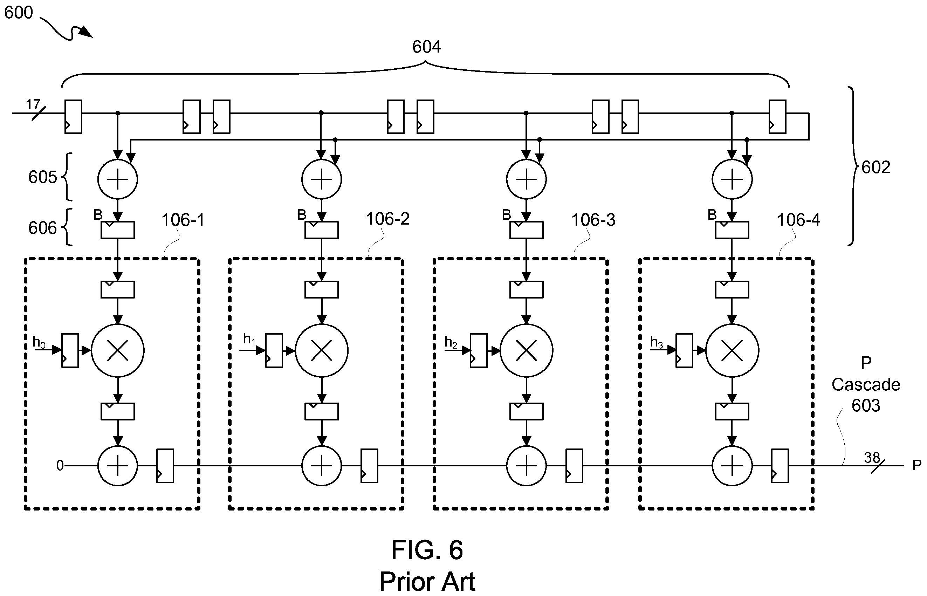

FIG. 6 is a block/circuit diagram depicting an example of an 8-tap even symmetric systolic finite impulse response ("FIR") filter 600 of the prior art. FIR filter 600 is made up of DSP blocks 106 having been programmed with an operational mode ("OPMODE"). Accordingly, DSP blocks 106-1 through 106-4 represent DSPs of the prior art having cascaded outputs to provide a resulting cascaded output, namely "P" cascade 603. Heretofore, shift-register logic ("SRL") 604 was formed of registers in FPGA fabric 602, and thus was an inhibiter to performance. Additionally, the preadder stage 605 and input register stage 606 were previously formed in FPGA fabric 602.

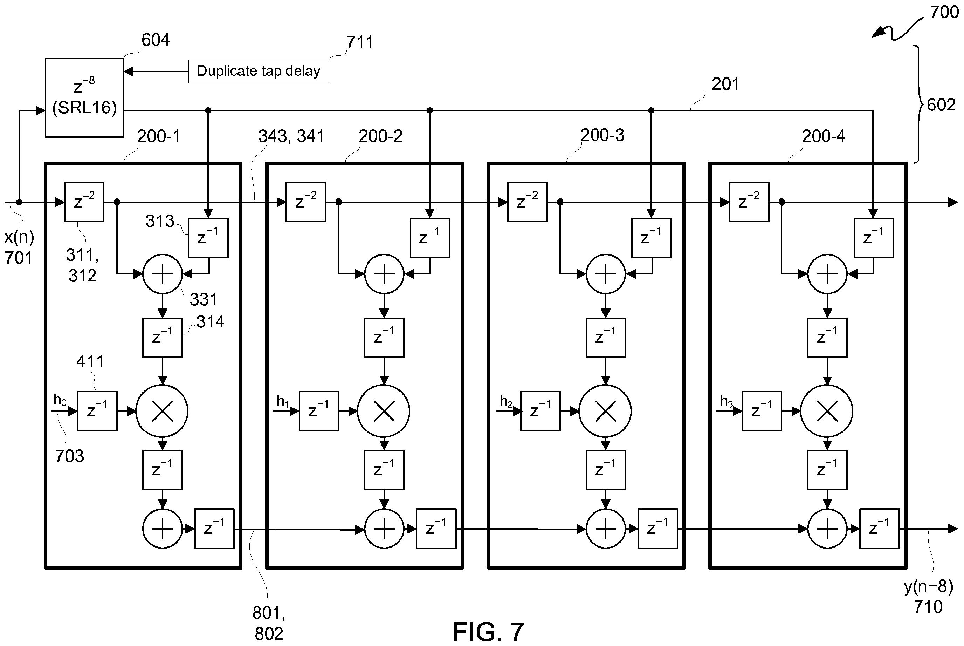

FIG. 7 is a block/circuit diagram depicting an exampleof an 8-tap even symmetric systolic FIR filter 700 having DSP slices 200-1 through 200-4. Each of DSP slices 200-1 through 200-4 may be a DSP slice 200 of FIG. 2. With renewed reference to FIGS. 2 through 4 and ongoing reference to FIG. 7, FIR filter 700 is further described. Even though an 8-tab filter is illustratively shown, it should be appreciated that fewer or more than 8 taps may be implemented, and fewer or more than four DSP slices 200 may thus be implemented. DSP slice 200-1 is set for OPMODE of 0,0,0,0,1 ,0,1 and DSP slices 200-2 through 200-4 are each set with OPMODEs 0,0,1 ,0,1 ,0,1. These OPMODEs are the same as for FIR filter 600 of FIG. 6, and, as they were previously known, are not described in unnecessary detail herein.

Even though FIR filter 700 is of a different design than FIR filter 600 of FIG. 6, if register 606 of FIR filter 600 is pushed to the inputs of preadder 605, then an A input, such as A input port 211 of FIG. 2 or filter input x(n) 701 of FIR filter 700, to a preadder 331 has two pipelined delay stages matching two tapped delay line values. Therefore, in contrast to tapping off a register delay line, such as SRL 604, to and connect to an A port register 606 for rebalancing, such tapping may be avoided as illustratively shown with FIR filter 700. Register 606 mirroring on an A input of preadder 605 may be avoided. In other words, such mirroring is not used because a two-deep A register output, namely A registers 311 and 312, may be used to provide for example the same raw data as previously provided via the mirrored path, and therefore such mirrored path may be eliminated. Thus, a mirror register with respect to a register 606 on a D input side of preadder 605 is in effect replaced with a D register 313 in FIR filter 700. A first register in 106-1 is thus a preadder output register, namely AD register 314 in DSP slice 200-1. Besides eliminating the extra register on the preadder A input of FIR filter 600, in FIR filter 700 it is not necessary to simultaneously tap off both A1 and A2 register inputs in contrast to FIR filter 600.

However, in contrast to FIR filter 600, for FIR filter 700, an input register stage 606 is moved to the inputs of the preadder stage 605, a preadder stage 605 along with input registers 606 may be implemented in DSPs, and only SRL 604 is implemented in FPGA fabric 602. SRL 604 is, e.g., a SRL 16, with eight register stages. Input to SRL 604 is filter input x(n) 701 , and output from SRL 604 is provided to each D register 313 of DSP slices 200-1 through 200-4 in parallel, namely broadcast.

Filter input x(n) 701 is also provided to an initial register of a chain of DSP slices 200-1 through 200-4. Inputs to FIR filter 700 may be obtained on or off chip with respect to an FPGA in which such FIR filter 700 is implemented. Filter input 701 is provided to A1 and A2 registers 311 and 312 of DSP slice 200-1 and then to A1 and A2 registers of each of the other DSP slices as in the form of a shift register, namely for sequential input. In this example, A1 register 311 and A2 register 312 of DSP slices 200-1 through 200-4 in combination have the same delay or number of register stages as SRL 604.

Filter input 701 to SRL 604 is D input 201 prior to being broadcast to DSP slices 200-1 through 200-4. In this example, because D input 201 is broadcast to each of DSP slices 200-1 through 200-4, it is implemented in FPGA fabric. Filter input 701 is also provided as input A 211 to DSP slice 200-1 , namely a first stage DSP slice. However, for input to DSP slices 200-2 through 200-4 such input is AC output 343 provided as AC input 341 to the next stage in the cascade.

Four coefficients h0 through h3 are respectively provided to B input ports, namely B inputs 212 of DSP slices 200-1 through 200-4. In this example, coefficients h0 through h3, namely coefficients 703, are provided to respective B input ports 212 of each of DSP slices 200-1 through 200-4, as such coefficients are not cascaded. In other words, BC input 441 and BC output 443 are not used in this example. Coefficients 703 may be input to either B1 registers 411 or B2 registers 412. For purposes of clarity by way of example and not limitation, it shall be assumed that B1 registers 411 are used; however, it should be appreciated that B2 registers 412 may be used instead of B1 registers 411 or a combination of B1 and B2 registers may be used.

A PC output 802 is cascaded with a PC input 801 between each of the DSP slices. A PC output of DSP slice 200-4 provides the resultant filter output y(n-8) 710. Duplicate tap delay 711 is input to SRL 604 in order to provide for timing adjustments.

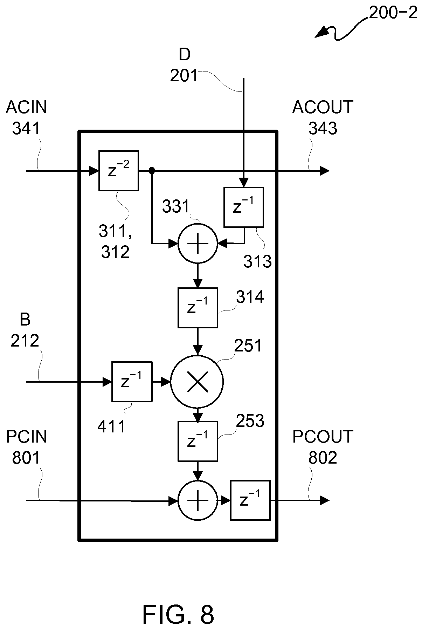

It should be appreciated that DSP slices 200 may be modeled using VHDL as modular components. FIG. 8 is a block/circuit diagram depicting an exemplary exampleof DSP slice 200-2. DSP slice 200-2 may have an OPMODE of 0,0,1 ,0,1 ,0,1 as previously described for this examplefor implementing a symmetric systolic add-multiply-add processing module.

Again, AC input 341 is provided to A1 and A2 registers 311 and 312 sequentially. Each D input 201 is provided to D register 313 and outputs of those registers are provided to adder/subtractor 331 in an add mode.

Again, output of registers 312 is sequentially provided as AC output 343 to a downstream DSP slice 200-3, namely the AC input 341 of such downstream DSP slice 200-3. Likewise, AC input 341 is obtained from the AC output 343 of an upstream DSP slice 200-1.

Each B input 212 receives a coefficient to a B register such as B1 register 411. Output of adder/subtractor 331 is provided to AD register 314 and outputs of registers 411 and 314 are provided to multiplier 251.

Output of multiplier 251 is provided to M register 253 and output of M register 253, which is provided to an adder and then a subsequent output register stage, as was done in the prior art and thus not described in unnecessary detail for purposes of clarity. Moreover, as done in the prior art and thus not described in unnecessary detail for purposes of clarity, PC input 801 , which may be obtained from a PC output 802 of an upstream DSP slice 200-1 is input to such adder for summing with the output of register 253, and the result of such add may be provided to an output register for providing PC output 802 to a downstream DSP slice 200-3.

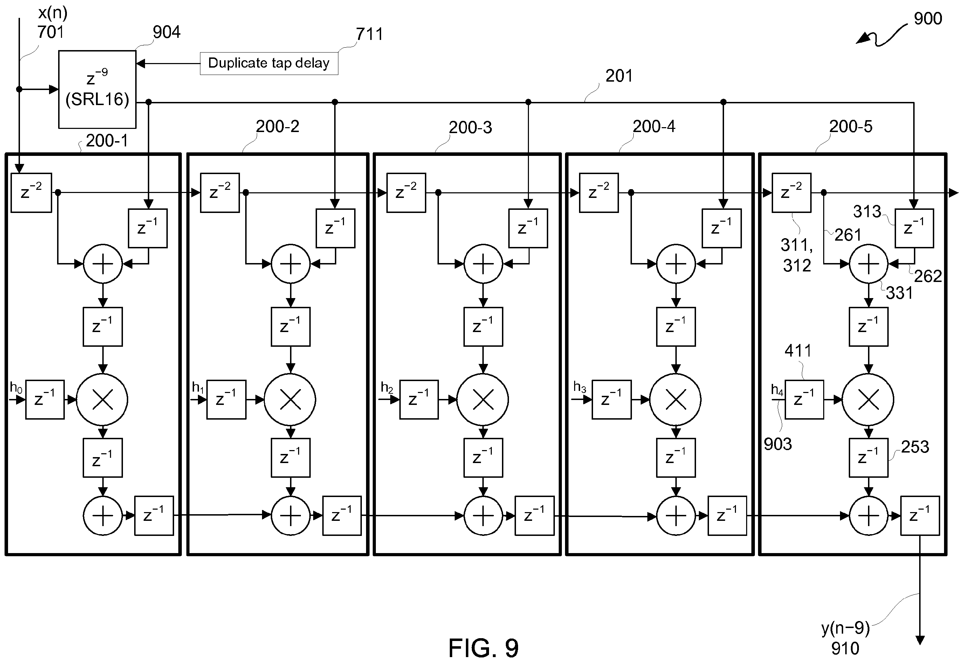

FIG. 9 is a block/circuit diagram depicting an exampleof a 9-tap odd symmetric systolic FIR filter 900. As FIR filter 900 is similar to FIR filter 700 of FIG. 7, only the differences are described for purposes of clarity. SRL 904 is a nine deep shift register for broadcasting D input 201 as previously described. An additional DSP slice, namely DSP slice 200-5 is added as a final stage for producing output y(n-9) 910. Additionally, an additional coefficient h4 of coefficients 903 is provided as an input to B register 411 of DSP slice 200-5. DSP slice 200-5 has the same OPMODE as DSP slices 200-2 through 200-4.

Even though D input 201 may be shifted to register 313 of DSP slice 200-5, DSP slice 200-5 is configured to disable use of D port or a zero is input on D input path 262 to adder/subtractor 331 in an add mode of DSP slice 200-5. Accordingly, it should be appreciated that using dynamic configuration, an odd slice, such as DSP slice 200-5, at a final stage of an FIR filter, such as FIR filter 900, may be dynamically changed for purposes of operating as an odd number of tap filter. Likewise, an A input path 261 may be dynamically changed such that contents in registers 311 and 312 do not show up at adder/subtractor 331 of DSP slice 200-5, but rather a logic 0 is provided to both input ports of adder/subtractor 331.

In other words, by setting inmodes 202-1 and 202-2 appropriately, both inputs to adder/subtractor 331 may be zero. Additionally, for an even number of filter taps, there would not be an odd coefficient, such as h4 903, and hence coefficient input for any unused tap may be a logic 1 or a logic 0. Thus, output from register 253 may be a logic 0 provided to a final stage adder to provide an output which is in effect y(n-8) 710 of Figure 7 with an extra pipeline delay. The resulting filter is an 8-tap filter that has the output latency of y(n-9) 910 of Figure 9. Thus, it should be appreciated that using inmodes 202-1 and 202-2 as previously described, and having an odd number of DSP slices, such a DSP filter may be dynamically adjustable to provide odd or even symmetric systolic FIR filtering. SRL 16 may be dynamically adjusted to accommodate different filter lengths. So, for the preceding example of converting a 9-tap filter to an 8-tap filter whose output is y(n-9) 910, the SRL 16 is z"8.

Additionally, in this example, there is a time lag in the operation or shifting of data into an FIR filter, and accordingly dynamic adjustment, as well as the data from one sequence of FIR operations to another sequence of FIR operations may be shadowed in. In other words, without waiting for completion of one FIR operation, such as an odd FIR operation, the data and parameters for a subsequent FIR operation may be shadowed into the FIR filter while still operating the FIR filter to complete the prior FIR operation sequence. The same is true for going from an odd FIR sequence of operations to an even FIR sequence of operations.

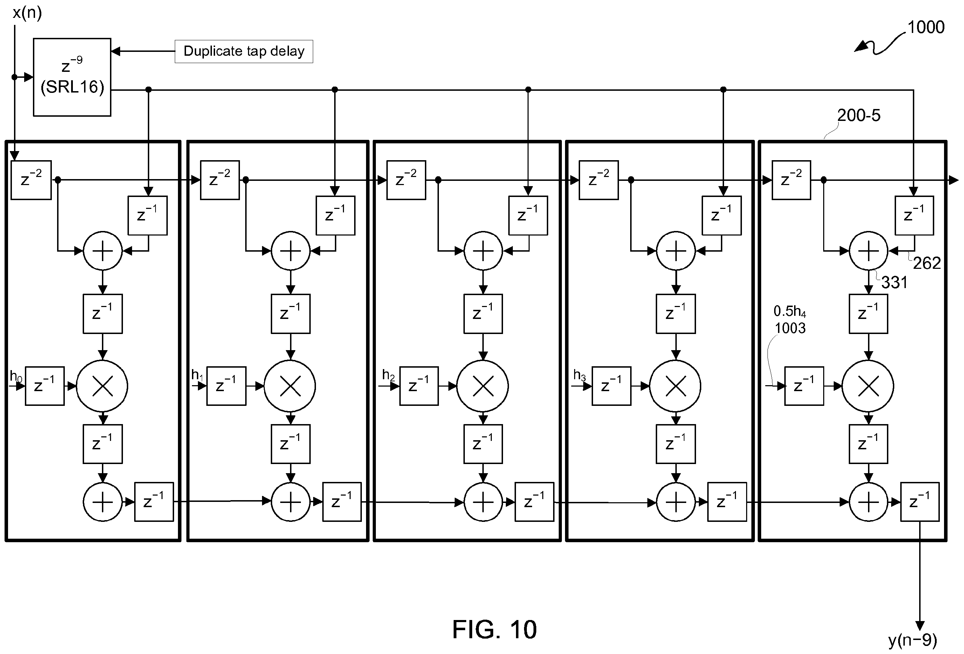

FIG. 10 is a block/circuit diagram depicting an exampleof a 9-tap odd symmetric systolic FIR filter 1000, which is an alternative to FIR filter 900 of FIG. 9. In this example, for an odd operation, adder/subtractor 331 is not in effect having a zero input from D input path 262. Thus, effectively the final DSP slice, which in this exampleis DSP slice 200-5, adds a number to itself, effectively doubling the number. Accordingly, coefficient 1003 is 0.5h4. This means that effectively 2x(n) is multiplied by 0.5h4 in DSP slice 200-5 in order to negate the effect of the add by adder/subtractor 331 of such slice. There may be some precision loss in coefficient 1003 in this example; however, this exampleallows tiling of DSP slices without having to dynamically adjust D input 201 via inmode 202-2.

In either of the examplesof FIGS. 9 and 10, the last DSP slice effectively bypasses the preadder operation for odd symmetric systolic FIR filtering. The last tap either uses a different processing or forces logic Os as operand inputs.

Accordingly, in this example, a multiple stage FIR filter may be implemented. Such an FIR filter may be implemented for a longest possible FIR use depending on the application. Such an FIR filter may be used for example in time division multiplexing application, where FIR filters of different lengths are dynamically set without reconfiguration of programmable logic. In other words, a shift register for broadcasting a D input 201 may be set up for the longest FIR filter of a user application; but the SRL delay is dynamically modified to match the number of taps in the filter.

Even though only the last DSP slice of an odd FIR filter was described for dynamic setting using inmode, it should be appreciated that any number of DSP slices at the end an FIR may be dynamically set as such. Accordingly, in the above described 9-tap FIR filter, such FIR filter may be dynamically adjusted from nine taps down to one tap, or even effectively no taps in a bypass mode, without reconfiguration of programmable logic used to implement a shift register. More generally, a filter input series, x(n), may be coupled for input to a chain of DSPs forming an FIR filter for providing a filter output series, y(n-p), where p is an integer number of the effective number of taps and is dynamically adjustable.

It should be appreciated that even though generally fixed coefficients were described, such coefficients may change from application to application. Again, because two-deep register buffering is used, shadowing of information from one FIR depth to the next FIR depth may be used where the transfer is staggered for each of the stages.

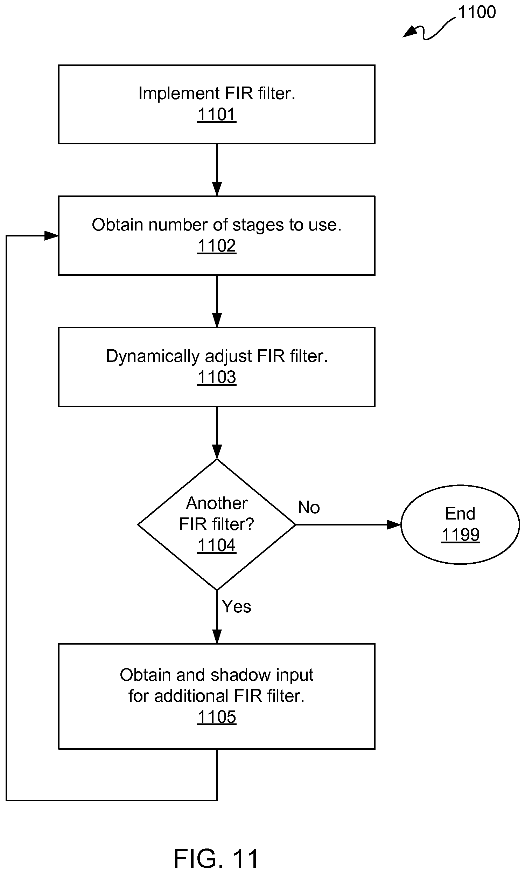

FIG. 11 is a flow diagram depicting an exampleof an FIR use flow 1100. At 1101 , an FIR filter is implemented having a longest number of stages among all applications to be used. At 1102, a number of stages to use for a then current application is obtained. At 1103, the FIR filter is dynamically adjusted, if not already the correct length, to accommodate the number of stages to be used as found at 1102. At 1104, it is determined whether another FIR sequence is to be performed. If no other FIR sequence is to be performed, flow 1100 may end at 1199. If another FIR sequence is to be performed as determined at 1104, then input for such other FIR sequence may be obtained and shadowed in at 1105 and the number of stages to use may be determined again at 1102 for dynamically adjusting (if needed) the FIR filter at 1103.

Accordingly, it should be appreciated that such a filter may be gated by gating logic for dynamically zeroing out the ending one or more DSP blocks to operate such a filter as having an even number of taps even though there are an odd number of the DSP blocks in the chain. Moreover, such gating logic may be used for dynamically zeroing out the ending one or more DSP blocks to operate such filter as having an odd number of taps even though there are an even number of the DSP blocks in the chain.

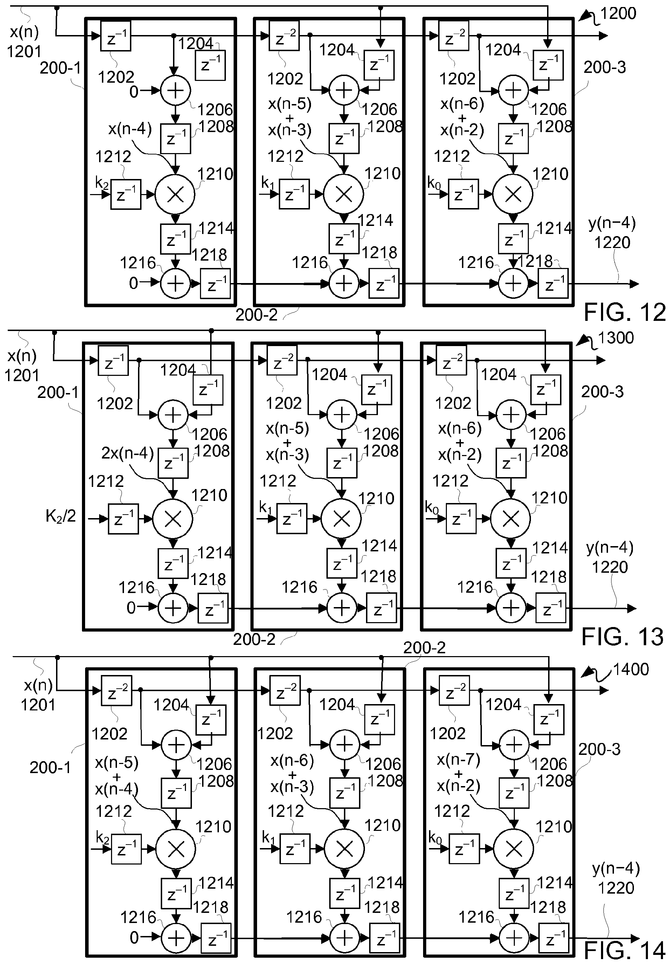

Turning now to Fig. 12, a block diagram of a circuit implementing a symmetric transpose convolution finite impulse response (FIR) filter according to an embodiment of the present invention is shown. The embodiment of Fig. 12 shows an arrangements of DSP blocks, which may comprise DSP slice 200, configured to enable a symmetric transpose convolution FIR filter using a pre-adder of the DSP block and having registers to provide the delays necessary for taps having a common coefficient to be multiplied by the common coefficient in a single DSP block. The selection of delays comprising registers will depend upon the function of the filter being implemented, where the appropriate delays in the DSP blocks of Figs. 12-14 may be implemented using the circuit of Fig. 3 set forth above, or some other suitable circuit. While the DSP blocks preferably comprise the same elements, they can be configured differently. By way of example, programmable interconnects, such as the programmable interconnects described above in reference to Fig. 1, may be used to connect the delays as shown or configuration bits may be used to select multiplexers as described in reference to Fig. 3.

Because the embodiment of Figs. 12-14 relate to a symmetric transpose convolution FIR filter having an odd number of taps, one of the DSP stages will receive only a single tap, while the other DSP stages will receive a plurality of taps having common coefficients. As configured in Figs. 12-14, the arrangement and configuration of DSP blocks enables the implementation of a symmetric transpose convolution FIR filter according to the equation y(n-4) = k₀*x(n-4) + k₁*x(n-5) + k₂*x(n-6) + k₁*x(n-7) + k₀*x(n-8), which written in factored form is k₀{x (n-4) + x(n-8)} + k₁{x(n-5) + x(n-7)}+ k₂*x(n-6) or in factored form as y(n-2)=k₀{x (n-2) + x(n-6)} + k₁{x(n-3) + x(n-5)}+ k₂*x(n-4) when expressed in the time frame of the inputs to the multiplier as shown in Figs. 12 and 13. The raw data index of each filter tap is shown for the inner product computation of y(n-4) result. Thus only the right most tap x(n-2) input to the multiplier 1210 aligns with x(n), while the other filter taps show the raw data at different snapshots in time. The delays, where z⁻¹ represents one delay and z⁻² represents two delays, may be implemented according to the Acascade pipeline delays (311 and 312) described above in Fig. 3. For example, the adder 1206 may be implemented by the adder/subtractor 331 of Fig. 6, where the selected delay values of the input signals to the adder/subtractor 331 are based upon the selection inputs to the multiplexers of Fig. 3 as set forth above.

In the embodiment of Fig. 12 showing a configuration 1200, the first stage 200-1 receives an input 1201 comprising an x(n) signal which is coupled to a first register 1202. As will be described in more detail below in reference to Fig. 13, a second register 1204 may be used. While an adder 1206 in the DSP stage 200-1 is shown coupled to receive the output of the register 1202 and zero, the adder 1206 may be coupled to receive the output of the registers 1202 and 1204 as shown in DSP stages 200-2 and 200-3, as well as the DSP stage 200-1 in configuration 1300 of Fig. 13. It should be noted that the adder 1206 may be implemented as a subtractor to process a coefficient having an inverted sign. A register 1208 is coupled to the output of the adder 1206 and has an output coupled to a multiplier 1210. The multiplier 1210 also receives a factor comprising a coefficient from a register 1212. A register 1214 at the output of the multiplier 1210 is also coupled to an adder 1216, the output of which is stored in a register 1218. While the input to the adder 916 is zero in the first stage 200-1, the adder 1216 may receive the output of a previous stage as shown in reference to DSP blocks 200-2 and 200-3. An output 1220 comprising a signal y(n-4) is generated at the register 1218 of the DSP stage 200-3.

It should be noted that the first stage comprises the middle tap of an odd number of taps and therefore only couples a single tap to the adder 1206. However, each of the second and third stages receives two taps having a common coefficient. According to the embodiment of Fig. 12, the second DSP stage 200-2 couples (x(n-5) + x(n-3)) to one input of the multiplier 1210 receiving the common coefficient k₁, while the third DSP stage 200-3 couples (x(n-6) + x(n-2)) to one input of the multiplier 1210 receiving the common coefficient k₀. The number of delays associated with the adder 1206 or the multiplier 1210 are selected to ensure that the correct inputs are received at the adder 1206 or multiplier 1210. For example, the correct number of delays may be selected by providing the appropriate multiplexer selection signals to the multiplexers of Fig. 3. As shown in Fig. 13, DSP stage 200-1 may be configured to implement register 1204, where 2x(n-4) is provided to one input of multiplier 1210 while k₂/2 is provided to the other input. While the embodiment of Figs. 12-12 shows one example of a symmetric transpose convolution FIR filter, it should be understood that filters represented by other equations could be implemented. Further, the embodiment of Figs. 12-13 could be used to implement any function where inputs may have a common coefficient, and may implement any number of factors having a common coefficient.

It should be noted that one or more circuits of the present invention function regardless of whether the initial number of taps is even or odd. As shown in the configuration 1400 of Fig. 14, a filter function having an odd number of taps is implemented. In particular, a block diagram of a circuit implementing a symmetric transpose convolution finite impulse response filter shows 6 taps being implemented in 3 DSP blocks according to the equation y(n-4) = k₀*x(n-4) + k₁*x(n-5) + k₂*x(n-6) + k₂*x(n-7) + k₁*x(n-8) + k₀*x(n-9), which written in factored form is y(n-4) = k₀{x(n-4) + x(n-9)} + k₁{x(n-5) + x(n-8)} + k₂{(x-6) + x(n-7)} or in factored from as y(n-2) = k₀{x(n-2) + x(n-7)} + k₁{x(n-3) + x(n-6)} + k₂{x(n-4) + x(n-5)} when expressed in the time frame of the inputs to the multiplier as shown in Fig. 14. As can be seen in Fig. 14, each stage receives two inputs having common coefficients, where the DSP of stage 200-1 receives the taps associated with the coefficient k₂, the DSP of stage 200-2 receives the taps associated with the coefficient k₁, the DSP of stage 200-3 receives the taps associated with the coefficient k₀.

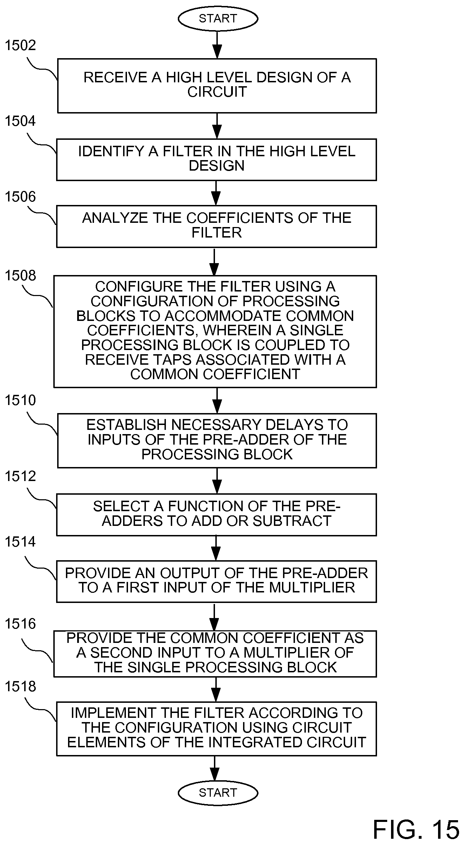

By employing a pre-adder where the arrival of data samples to the pre-adders in the desired clock cycles is controlled through the ACOUT/ACIN propagation path, a filter consuming less device resources and consuming less power may be implemented. That is, rather than implementing the filter of Figs. 12-13 in five DSP blocks or the filter of Fig. 14 in six DSP blocks, each of the filters may be implemented in three DSP blocks. Further, as will be described in more detail below in reference to Fig. 15, a methodology enables the transformation from a generic, non-optimized, high level description of a filter to the optimized form. This methodology is not only usable by anyone trying to manually describe such filter in an optimal way, but may also be automated as a new advanced inference capability in any synthesis tool. That is, rather than a user providing a description of the DSP block as implemented in Figs. 12-14 for example, the synthesis tool will automatically detect the symmetric coefficients and configure the DSP block to take advantage of a pre-adder, such as the adder 1206, thereby reducing the number of DSP blocks required to implement the filter. Accordingly, one or more circuits and methods of the present invention leverages the symmetry of coefficients to minimize the number of cascaded DSP blocks by using a pre-adder of the DSP to perform symmetric combining.

It should be noted that one or more circuits and methods of the present invention do not result in any penalty in terms of circuit performance compared to other implementations, such as a systolic filter implementation. The DSP block chain is optimized in both cases through the use of fast connections including Pcascade (PCOUT/PCIN) and Acascade (ACOUT/ACIN) between the DSP blocks. In addition, it should be noted that one or more circuits and methods of the present invention ensure that each DSP block in the chain is fully pipelined for optimal performance through the use of available pipelining stages in those blocks, including registers 1202, 1204, 1208, 1214 and 1218. In addition, a fanout equal to the number of DSP stages is implied in both cases. For a systolic implementation, it is found at the output of the shift register, while it is found on the incoming data node itself for the transpose convolution implementation set forth above.

Finally, it should be noted that the transformation principle is generic, and works when there is a sign inversion between symmetric coefficients, such as coefficients having signs -k2 -k1 -kθ k0 k1 k2 or when there is no sign inversion. Although it may not necessarily address known or common filter applications today, one or more circuits and methods of the present invention could even be applied in mixed situations where some of the coefficients are sign inverted while others are not, such as coefficients having signs of -k2 k1 k0 k0 k1 k2.

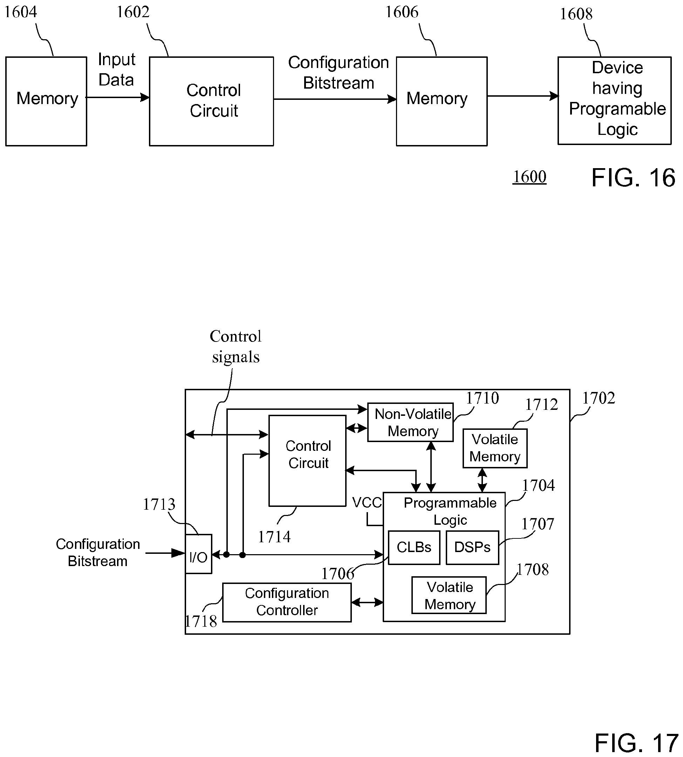

Turning now to Fig. 15, a flow chart shows a method of implementing a filter in an integrated circuit according to an embodiment of the present invention. The method of Fig. 15 may be implemented in any of the Figs. 1 -14 as described above, or some other suitable circuits. A high level design of a circuit is received at a step 1502. For example, the high level design may be an HDL description or some other high level language description of a circuit having a filter. As set forth above, the description of the filter may be as simple as a description of the filter based upon coefficients and associated taps. A filter in the high level design is identified at a step 1504. The coefficients of the filter are analyzed at a step 1506. The filter is configured using a configuration of processing blocks to accommodate common coefficients, where a single processing block is coupled to receive taps associated with a common coefficient at a step 1508. The configuration of processing blocks may be implemented as shown and described in reference to Figs. 12-14, for example. Necessary delays to inputs of the pre-adder of the processing block are established at a step 1510. A function of the pre-adders is selected to add or subtract at a step 1512 based upon the signs of the coefficients in an equation representing the filter. An output of the pre-adder is provided to a first input of the multiplier at a step 1514. The 52534429-1-GM CGLAS HAN common coefficient is provided as a second input to a multiplier of the single processing block at a step 1516. Finally, the filter is implemented according to the configuration using circuit elements of the integrated circuit at a step 1518. A computer program code could be implemented in a control circuit, such as control circuit 1602 as will be described in more detail below in reference to Fig. 16. The computer program code may comprise a computer-readable medium having computer-readable program code that transforms a circuit design to a placement configuration, where the computer-readable medium comprises: computer-readable program code that identifies a filter in a high level design; computer-readable program code that analyzes the coefficients of the filter; and computer-readable program code that configures the filter using a processing block of the circuit configured to accommodate a common coefficient, where the processing block is coupled to receive taps associated with the common coefficient.

The computer-readable program code that configures the filter using a processing block configured to accommodate a common coefficient may comprise computer-readable program code that configures the filter as a symmetric transpose convolution filter. The computer-readable program code that analyzes the coefficients of the filter may comprise computer-readable program code that identifies symmetrical coefficients of the filter. The computer program product may further comprise computer-readable program code that provides the common coefficient as a first input to a multiplier of the processing block. The computer program product may further comprise computer-readable program code that provides a sum or difference of the taps associated with the common coefficient as a second input to the multiplier. The computer-readable program code that provides a sum or difference of the taps associated with the common coefficient as a second input to the multiplier may comprise computer-readable program code that generates the sum using a pre-adder circuit of a DSP block. The computer program product may further comprise computer-readable program code that implements the filter using circuit elements of the integrated circuit. The computer program product may have other features or be a part of a larger program for implementing a circuit in an integrated circuit.

Fig. 16 shows a block diagram of a system 1600 for implementing a device having programmable resources according to an embodiment of the present invention. In particular, a control circuit 1602 is coupled to receive input data from a memory 1604, and generate a configuration bitstream which is stored in a memory 1606. As will be described in more detail below, the input data may comprise a circuit design described as a high level design, such as a circuit design defined in a hardware description language (HDL) such as VHDL. The control circuit may comprise a computer running software which generates a configuration bitstream which is stored in the memory 1606. The configuration bitstream comprises a placement configuration which provides information related to the placement of components, such as components of DSP circuits of a circuit design to be implemented in a device. Memory 1606 comprises a non-volatile memory for storing the configuration bitstream for loading it into an integrated circuit device having programmable resources 1608. The programmable resources may be programmable logic as described in more detail below, or other programmable elements of an integrated circuit. While one or more methods of the present invention may be applied to the placement of DSP circuits in any type of integrated circuit, the methods find particular application to devices having programmable logic, and are described in reference to devices having programmable logic in detail below. As will be described in more detail below, the control circuit 102 generates a configuration bitstream having an optimized placement of DSP circuits.

The software flow for the design of a device having programmable resources comprises synthesis, packing, placement and routing, as is well known in the art. Synthesis comprises the step of converting a circuit design in a high level design to a configuration of elements found in the device having programmable logic. For example, a synthesis tool operated by the control circuit 1602 may implement the portions of a circuit design implementing certain functions in configurable logic blocks (CLBs) or DSP blocks, as will be described in more detail below. An example of a synthesis tool which may implement one or more methods of the present invention is the ISE™ tool available from Xilinx, Inc. of San Jose CA, where the output of a synthesis tool implementing one or more methods of the present invention comprises a configuration bitstream having an optimized configuration of DSP blocks. Packing comprises the step of grouping portions of the circuit design into defined blocks of the device, such as configurable logic blocks. As will be described in more detail below, the packing of DSP circuits into DSP blocks may be implemented efficiently according to various methods of the present invention. Placing comprises the step of determining the location of the blocks of the device defined during the packing step, where the blocks in a design are placed on the two-dimensional grid associated with sites of the device. Placement is performed by a placer, which may comprise placement software running on a computer, or a portion of a larger software package running on a computer for implementing the circuit design in the device. Finally, routing comprises selecting paths of interconnect elements, such as programmable interconnects, in a device having programmable logic.

One or more circuits and methods of the present invention enable an implementation of symmetric transpose convolution filters that optimally uses a pre-adder capability, while removing the need for any logic outside of the DSP blocks. As a result, resource requirements and power dissipation are reduced compared to other filter implementations such as a symmetric systolic FIR filter, or other circuits implementing symmetric transpose convolution filters. In addition, the circuits and methods set forth below solve the need for designers to manually fine-tune the description of the filters used in their circuits by introducing a methodology that will allow a synthesis tool to take a generic high level design description of a filter and to perform the fine tuning and optimization work automatically through enhanced capabilities to infer the filter design.

One or more circuits and methods of the present invention enable a symmetric transpose convolution filter implementation that is not only minimal in terms of required DSP stages, but also removes the need for any logic outside the DSP blocks. The circuits and methods therefore further reduce device utilization and static and dynamic power dissipation. For designers that either lack deep knowledge of the characteristics of the DSP blocks, or that are looking for portable solutions which would not tie them to a particular device or device manufacturer, the ability of a synthesis tool to take some generically described filter code, such as HDL code, and perform the transformation to an optimized implementation is beneficial. Therefore, an inference and optimization methodology that can be automated in a synthesis tool is described. As will be described in more detail below, the methodology enables designers leveraging such enabled tools to be able to describe symmetric transpose convolution filters in a generic way. For example, designers may merely describe a sum of products and a table of coefficients to apply to each tap of a given filter to achieve an optimal implementation generated by the synthesis tools.

Turning now to Fig. 17, a block diagram of a device having programmable logic according to an embodiment of the present invention is shown. A device 1702 incorporates programmable logic 1704, where the programmable logic may comprise CLB circuits 1706, DSP circuits 1707, and volatile memory 1708, and may be coupled to other circuits such as a non-volatile memory 1710 and/or a volatile memory 1712. The non-volatile memory 1710 may be coupled to an I/O port 1713 of the device, enabling a control circuit 1714 to load a configuration bitstream from the I/O port 1713 into the non-volatile memory 1710 of the device.

The configuration bitstream may be loaded into the non-volatile memory 1710 of the device 1702, and then loaded into the volatile memory 1708 and the volatile memory 1712. Alternatively, the configuration bitstream may be loaded directly into the volatile memory 1708 and the volatile memory 1712 by the control circuit 1714 or the configuration controller 1718. The volatile memory 1708 may be associated with configurable logic blocks, while the volatile memory 1712 may be associated with blocks of random access memory (BRAMs) or with configuration memory cells, for example. As will be described in more detail below, a configuration bitstream will be generated to implement the DSP circuits 1707 of the programmable logic 1704.

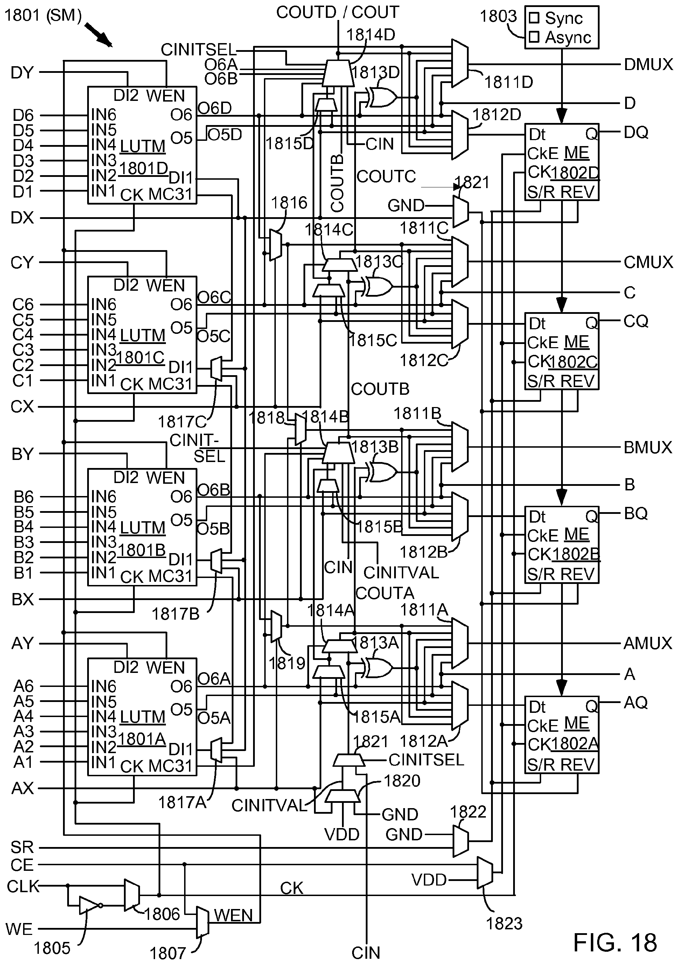

Turning now to Fig. 18, a block diagram of a configurable logic element of the device of Fig. 1 according to an embodiment of the present invention is shown. In particular, Fig. 18 illustrates in simplified form a configurable logic element of a configuration logic block 102 of Fig. 1. In the embodiment of Fig. 18, slice M 1801 includes four lookup tables (LUTMs) 1801A-1801 D, each driven by six LUT data input terminals A1-A6, B1-B6, C1-C6, and D1-D6 and each providing two LUT output signals 05 and 06. The 06 output terminals from LUTs 1801A-1801 D drive slice output terminals A-D, respectively. The LUT data input signals are supplied by the FPGA interconnect structure via input multiplexers, which may be implemented by programmable interconnect element 1811, and the LUT output signals are also supplied to the interconnect structure. Slice M also includes: output select multiplexers 1811A-1811 D driving output terminals AMUX-DMUX; multiplexers 1812A-1812D driving the data input terminals of memory elements 1802A-1802D; combinational multiplexers 1816, 1818, and 1819; bounce multiplexer circuits 1822-1823; a circuit represented by inverter 1805 and multiplexer 1806 (which together provide an optional inversion on the input clock path); and carry logic comprising multiplexers 1814A-1814D, 1815A-1815D, 1820-1821 and exclusive OR gates 1813A-1813D. All of these elements are coupled together as shown in Fig. 18. Where select inputs are not shown for the multiplexers illustrated in Fig. 18, the select inputs are controlled by configuration memory cells. That is, configuration bits of the configuration bitstream stored in configuration memory cells are coupled to the select inputs of the multiplexers to select the correct inputs to the multiplexers. These configuration memory cells, which are well known, are omitted from Fig. 18 for clarity, as well as from other selected figures herein.

In the pictured embodiment, each memory element 1802A-1802D may be programmed to function as a synchronous or asynchronous flip-flop or latch. The selection between synchronous and asynchronous functionality is made for all four memory elements in a slice by programming Sync/Asynch selection circuit 1803. When a memory element is programmed so that the S/R (set/reset) input signal provides a set function, the REV input terminal provides the reset function. When the memory element is programmed so that the S/R input signal provides a reset function, the REV input terminal provides the set function. Memory elements 1802A-1802D are clocked by a clock signal CK, which may be provided by a global clock network or by the interconnect structure, for example. Such programmable memory elements are well known in the art of FPGA design. Each memory element 1802A-1802D provides a registered output signal AQ-DQ to the interconnect structure. Because each LUT 1801A-1801 D provides two output signals, 05 and 06, the LUT may be configured to function as two 5-input LUTs with five shared input signals (IN1-IN5), or as one 6-input LUT having input signals IN1-IN6.

In the embodiment of Fig. 18, each LUTM 1801A-1801D may function in any of several modes. When in lookup table mode, each LUT has six data input signals IN1-IN6 that are supplied by the FPGA interconnect structure via input multiplexers. One of 64 data values is programmably selected from configuration memory cells based on the values of signals IN1-IN6. When in RAM mode, each LUT functions as a single 64-bit RAM or two 32-bit RAMs with shared addressing. The RAM write data is supplied to the 64-bit RAM via input terminal DI1 (via multiplexers 1817A-1817C for LUTs 1801A-1801C), or to the two 32-bit RAMs via input terminals DI1 and DI2. RAM write operations in the LUT RAMs are controlled by clock signal CK from multiplexer 1806 and by write enable signal WEN from multiplexer 1807, which may selectively pass either the clock enable signal CE or the write enable signal WE. In shift register mode, each LUT functions as two 16-bit shift registers, or with the two 16-bit shift registers coupled in series to create a single 32-bit shift register. The shift-in signals are provided via one or both of input terminals DI1 and DI2. The 16-bit and 32-bit shift out signals may be provided through the LUT output terminals, and the 32-bit shift out signal may also be provided more directly via LUT output terminal MC31. The 32-bit shift out signal MC31 of LUT 1801 A may also be provided to the general interconnect structure for shift register chaining, via output select multiplexer 1811 D and CLE output terminal DMUX.

While the foregoing describes exemplary embodiment(s) and examples in accordance with one or more aspects of the invention, other and further embodiment(s) in accordance with the one or more aspects of the invention may be devised without departing from the scope thereof, which is determined by the claim(s) that follow and equivalents thereof. Claim(s) listing steps do not imply any order of the steps. Trademarks are the property of their respective owners.

## Claims

1. A symmetric transpose convolution FIR filter of an integrated circuit, comprising:
an input signal;
a first DSP stage (200-1) to receive the input signal (1201) and a first coefficient (k₂), wherein the first DSP stage (200-1) comprises:
a first pre-adder (1206) coupled to receive the input signal (1201) at a first register (1202) with an associated one cycle delay (z⁻¹) and a zero input;
a second register (1208) coupled to an output of the first pre-adder (1206);
a third register (1212) coupled to receive the first coefficient (k₂);
a first multiplier (1210) coupled to the second register (1208) and the third register (1212);
a fourth register (1214) coupled to an output of the first multiplier (1210);
a fifth register (1218) coupled to store an output of the first DSP stage (200-1); and
a first adder (1216) coupled to the fourth register (1214) and a zero input,
wherein an output of the first adder (1216) is coupled to the fifth register (1218); and
a second DSP stage (200-2) to receive the input signal (1201), a first common coefficient (k₁), a first tap associated with the first common coefficient (k₁) from the first register (1202) of the first DSP stage (200-1), and the output of the first DSP stage (200-1), wherein the second DSP stage (200-2) comprises:
a second pre-adder (1206) coupled to receive the first tap from the first register (1202) of the first DSP stage (200-1) at a sixth register (1202) with an associated two cycle delay (z⁻²) and the input signal (1201) at a seventh register (1204) with an associated one cycle delay (z⁻¹), such that inputs are received from the sixth register (1202) and the seventh register (1204) at the second pre-adder (1206);
an eighth register (1208) coupled to an output of the second pre-adder (1206);
a ninth register (1212) coupled to receive the first common coefficient (k₁);
a second multiplier (1210) coupled to the eighth register (1208) and the ninth register (1212);
a tenth register (1214) coupled to an output of the second multiplier (1210);
an eleventh register (1218) coupled to store an output of the second DSP stage (200-2); and
a second adder (1216) coupled to the tenth register (1214) and the output of the first DSP stage (200-1), wherein an output of the second adder (1216) is coupled to the eleventh register (1218); and
a third DSP stage (200-3) to receive the input signal (1201), a second common coefficient (k₀), a second tap associated with the second common coeffcient (k₀) from the sixth register (1202) of the second DSP stage (200-2), and an output of the second DSP stage (200-2), wherein the third DSP stage (200-3) comprises:
a third pre-adder (1206) coupled to receive the second tap from the sixth register (1202) of the second DSP stage (200-2) at a twelfth register (1202) with an associated two cycle delay (z⁻²) and the input signal at a thirteenth register (1204) with an associated one cycle delay (z⁻¹), such that inputs are received from the twelfth register (1202) and the thirteenth register (1204) at the third pre-adder (1206);
a fourteenth register (1208) coupled to an output of the third pre-adder (1206);
a fifteenth register (1212) coupled to receive the second common coefficient (k₀);
a third multiplier (1210) coupled to the fourteenth register (1208) and the fifteenth register (1212);
a sixteenth register (1214) coupled to an output of the third multiplier (1210);
a seventeenth register (1218) to store an output of the third DSP stage (200-3); and
a third adder (1216), coupled to the sixteenth register (1214), to add an output of the third multiplier (1210) to the output of the second DSP stage (200-2), wherein an output of the third adder (1216) is coupled to the seventeenth register (1218).

2. The filter of claim 1 wherein the first pre-adder comprises a pre-adder circuit comprising:
a control bus (INMODE) coupled to the first pre-adder for dynamically controlling operation of the first pre-adder;
a first input port of a first multiplexer (306) coupled to the control bus (INMODE);
a second input port of a first logic gate (322) coupled to the control bus (INMODE);
a third input port of a second logic gate (321) coupled to the control bus (INMODE); and
a fourth input port of an adder/subtractor (331) coupled to the control bus (INMODE).

3. The filter of claim 2 wherein the first pre-adder circuit is configured for dynamically setting a fifth data input port of the adder/subtractor to receive a value of zero via output of the second logic gate in response to input from the fourth input port.

4. The filter of claim 3 wherein the first pre-adder circuit is configured for dynamically setting the fourth data input port of the adder/subtractor to receive the value of zero via the output of the second logic gate in response to input to the third input port.

5. The filter of any one of claims 2-4, wherein the first pre-adder circuit is configured for dynamically selecting input data having either a 0-, 1-, or 2-register delay in response to input to the first input port.

6. The filter of any one of claims 2-4, wherein the first pre-adder circuit is configured for dynamically setting the adder/subtractor for either adding or subtracting in response to input to the fourth input port.

7. A method of configuring a filter in a circuit implemented in an integrated circuit and having a plurality of DSP stages (200-1, 200-2, 200-3), wherein each DSP stage (200-2, 200-3) after a first DSP stage (200-1) is coupled to receive an input signal (1201), a common coefficient (k₁, k₀), a tap associated with the common coefficient (k₁, k₀), and an output of the preceding DSP stage, wherein the first DSP stage (200-1) comprises:
a pre-adder (1206) coupled to receive the input signal (1201) at a first register (1202) with an associated one cycle delay (z⁻¹) and a zero input;
a second register (1208) coupled to an output of the pre-adder (1206);
a third register (1212) coupled to receive a first coefficient (k₂);
a multiplier (1210) coupled to the second register (1208) and the third register (1212);
a fourth register (1214) coupled to an output of the multiplier (1210);
a fifth register (1218) to store an output of the first DSP stage (200-1); and
an adder (1216) coupled to the fourth register (1214) and a zero input,
wherein an output of the adder (1216) is coupled to the fifth register (1218); and wherein each DSP stage (200-2, 200-3) after the first DSP stage (200-1) comprises:
a pre-adder (1206) coupled to receive a tap from the first register (1202) of the preceding DSP stage at a sixth register (1202) with an associated two cycle delay (z⁻²) and the input signal at a seventh register (1204) with an associated one cycle delay (z⁻¹), such that inputs are received from the sixth register (1202) and the seventh register (1204) at the second pre-adder (1206);
an eighth register (1208) coupled an output of the pre-adder (1206);
a ninth register (1212) coupled to receive the common coefficient (k₁, k₀);
a multiplier (1210) coupled to the eighth register (1208) and the ninth register (1212);
a tenth register (1214) coupled to an output of the multiplier (1210);
an eleventh register (1218) to store an output of the DSP stage (200-2, 200-3); and
an adder (1216) coupled to the tenth register (1214) and the output of the previous DSP stage, wherein an output of the adder (1216) is coupled to the eleventh register (1218);
the method comprising:
receiving a high level design of the circuit;
identifying a filter in the high level design;
analyzing coefficients of the filter;
transforming the filter of the high level design to a symmetrical transpose convolution FIR filter, implemented in the integrated circuit, using the plurality of DSP stages, wherein each DSP stage of the plurality of DSP stages after the first DSP stage is configured to accommodate the common coefficient associated with the DSP stage, and wherein the filter receives the input signal at the first DSP stage, and each DSP stage after the first DSP stage is coupled to receive a tap associated with the common coefficient for the DSP stage.

8. The method of claim 7 further comprising, for each DSP stage after the first DSP stage, providing the common coefficient as a first input to the multiplier (1210) of the DSP stage.

9. The method of claim 8 further comprising, for each DSP stage after the first DSP stage, providing a sum of taps associated with the common coefficient as a second input to the multiplier.

10. The method of claim 9 wherein providing the sum of the taps associated with the common coefficient as a second input to the multiplier comprises generating the sum using the pre-adder circuit (1206) of the DSP block.

11. The method of claim 8 further comprising, for each DSP stage after the first DSP stage, providing a difference of taps associated with the common coefficient as a second input to the multiplier.

12. A symmetric transpose convolution FIR filter of an integrated circuit, comprising:
an input signal;
a first DSP stage (200-1) to receive the input signal (1201) and a first common coefficient (k₂), wherein the first DSP stage (200-1) comprises:
a first pre-adder (1206) coupled to receive the input signal (1201) at a first register (1202) with an associated two cycle delay (z⁻²) and at a second register (1204) with an associated one cycle delay (z⁻¹), such that inputs are received from the first register (1202) and the second register (1204) at the first pre-adder (1206);
a third register (1208) coupled to an output of the first pre-adder (1206);
a fourth register (1212) coupled to receive the first common coefficient (k₂);
a first multiplier (1210) coupled to the third register (1208) and the fourth register (1212);
a fifth register (1214) coupled to an output of the first multiplier (1210);
a sixth register (1218) coupled to store an output of the first DSP stage (200-1); and
a first adder (1216) coupled to the fifth register (1214) and a zero input, wherein an output of the first adder (1216) is coupled to the sixth register (1218); and
a second DSP stage (200-2) to receive the input signal (1201), a second common coefficient (k₁), a first tap associated with the second common coefficient (k₁) from the first register (1202) of the first DSP stage (200-1), and an output of the first DSP stage (200-1), wherein the second DSP stage (200-1) comprises:
a second pre-adder (1206) coupled to receive the first tap from the first register (1202) of the first DSP stage (200-1) at a seventh register (1202) with an associated two cycle delay (z⁻²) and the input signal (1201) at an eighth register (1204) with an associated one cycle delay (z⁻¹), such that inputs are received from the sixth register (1202) and the seventh register (1204) at the second pre-adder (1206);
a ninth register (1208) coupled to an output of the second pre-adder (1206);
a tenth register (1212) coupled to receive the second common coefficient (k₁);
a second multiplier (1210) coupled to the ninth register (1208) and the tenth register (1212);
an eleventh register (1214) coupled to an output of the second multiplier (1210);
a twelfth register (1218) to store an output of the second DSP stage (200-2); and
a second adder (1216) coupled to the eleventh register (1214) and the output of the first DS P stage (200-1), wherein an output of the second adder (1216) is coupled to the twelfth register (1218); and
a third DSP stage (200-3) to receive the input signal (1201), a third common coefficient (k₀), a second tap associated with the third common coefficient (k₀) from the seventh register (1202) of the second DSP stage (200-2), and an output of the second DSP stage (200-2), wherein the third DSP stage (200-3) comprises:
a third pre-adder (1206) coupled to the second tap from the seventh register (1202) of the second DSP stage (200-2) at a thirteenth register (1202) with an associated two cycle delay (z⁻²) and the input signal at a fourteenth register (1204) with an associated one cycle delay (z⁻¹), such that inputs are received from the twelfth register (1202) and the thirteenth register (1204) at the third pre-adder (1206);
a fifteenth register (1208) coupled to an output of the third pre-adder (1206);
a sixteenth register (1212) coupled to receive the third common coefficient (k₀);
a third multiplier (1210) coupled to the fifteenth register (1208) and the sixteenth register (1212);
a seventeenth register (1214) coupled to an output of the third multiplier (1210);
an eighteenth register (1218) to store an output of the third DSP stage (200-3); and
a third adder (1216), coupled to the seventeenth register (1214), to add an output of the third multiplier (1210) to the output of the second DSP stage (200-2), wherein an output of the third adder (1216) is coupled to the eighteenth register (1218).

13. A symmetric transpose convolution FIR filter of an integrated circuit, comprising:
an input signal (1201);
a first DSP stage (200-1) to receive the input signal (1201) and a first common coefficient (k₂/2), wherein the first DSP stage (200-1) comprises:
a first pre-adder (1206) coupled to receive the input signal (1201) at a first register (1202) with an associated one cycle delay and at a second register (1204) with an associated one cycle delay, such that the same inputs are received from the first register (1202) and the second register (1204) at the first pre-adder (1206);
a third register (1208) coupled to an output of the first pre-adder (1206);
a fourth register (1212) coupled to receive the first common coefficient (k₂/2);
a first multiplier (1210) coupled to the third register (1208) and the fourth register (1212);
a fifth register (1214) coupled to an output of the first multiplier (1210);
a sixth register (1218) coupled to store an output of the first DSP stage (200-1); and
a first adder (1216) coupled to the fifth register (1214) and a zero input, wherein an output of the first adder (1216) is coupled to the sixth register (1218); and
a second DSP stage (200-2) to receive the input signal (1201), a second common coefficient (k₁), a first tap associated with the second common coefficient (k₁) from the first register (1202) of the first DSP stage (200-1), and an output of the first DSP stage (200-1), wherein the second DSP stage (200-2) comprises:
a second pre-adder (1206) coupled to receive the first tap from the first register (1202) of the first DSP stage (200-1) at a seventh register (1202) with an associated two cycle delay (z⁻²) and the input signal at an eighth register (1204) with an associated one cycle delay (z⁻¹), such that inputs are received from the sixth register (1202) and the seventh register (1204) at the second pre-adder (1206);
a ninth register (1208) coupled to an output of the second pre-adder (1206);
a tenth register (1212) coupled to receive the second common coefficient (k₁);
a second multiplier (1210) coupled to the ninth register (1208) and the tenth register (1212);
an eleventh register (1214) coupled to an output of the second multiplier (1210);
a twelfth register (1218) to store an output of the second DSP stage (200-2); and
a second adder (1216) coupled to the eleventh register (1214) and the output of the first DSP stage (200-1), wherein an output of the second adder (1216) is coupled to the tweifth register (1218); and
a third DSP stage (200-3) to receive the input signal (1201), a third common coefficient (k₀), a second tap associated with the third common coefficient (k₀) from the seventh register (1202) of the second DSP stage (200-2), and an output of the second DSP stage (200-2), wherein the third DSP stage (200-3) comprises:
a third pre-adder (1206) coupled to the second tap from the seventh register (1202) of the second DSP stage (200-2) at a thirteenth register (1202) with an associated two cycle delay (z⁻²) and the input signal (1201) at a fourteenth register (1204) with an associated one cycle delay (z⁻¹), such that inputs are received from the twelfth register (1202) and the thirteenth register (1204) at the third pre-adder (1206);
a fifteenth register (1208) coupled to an output of the third pre-adder (1206);
a sixteenth register (1212) coupled to receive the third common coefficient (k₀);
a third multiplier (1210) coupled to the fifteenth register (1208) and the sixteenth register (1212);
a seventeenth register (1214) coupled to an output of the third multiplier (1210);
an eighteenth register (1218) to store an output of the third DSP stage (200-3); and
a third adder (1216), coupled to the seventeenth register (1214), to add an output of the third multiplier (1210) to the output of the second DSP stage (200-2), wherein an output of the third adder (1216) is coupled to the eighteenth register (1218).

## Patentansprüche

1. Symmetrisches transponiertes Faltungs-FIR-Filter einer integrierten Schaltung, Folgendes umfassend:
ein Eingangssignal;
eine erste DSP-Stufe (200-1) zum Empfangen des Eingangssignals (1201) und eines ersten Koeffizienten (k₂), worin die erste DSP-Stufe (200-1) Folgendes umfasst:
einen ersten Voraddierer (1206), gekoppelt zum Empfangen des Eingangssignals (1201) an einem ersten Register (1202) mit einer assoziierten Ein-Zyklus-Verzögerung (z⁻¹) und einer Null-Eingabe;
ein zweites Register (1208), an einen Ausgang des ersten Voraddierers (1206) gekoppelt;
ein drittes Register (1212), zum Empfangen des ersten Koeffizienten (k₂) gekoppelt;
einen ersten Multiplizierer (1210), an das zweite Register (1208) und das dritte Register (1212) gekoppelt;
ein viertes Register (1214), an einen Ausgang des ersten Multiplizierers (1210) gekoppelt;
ein fünftes Register (1218), zum Speichern einer Ausgabe der ersten DSP-Stufe (200-1) gekoppelt; und
einen ersten Addierer (1216), an das vierte Register (1214) und eine Null-Eingabe gekoppelt, worin ein Ausgang des ersten Addierers (1216) an das fünfte Register (1218) gekoppelt ist; und
eine zweite DSP-Stufe (200-2) zum Empfangen des Eingangssignals (1201), eines ersten gemeinsamen Koeffizienten (k₁), eines ersten Abgriffs, assoziiert mit dem ersten gemeinsamen Koeffizienten (k₁) vom ersten Register (1202) der ersten DSP-Stufe (200-1), und der Ausgabe der ersten DSP-Stufe (200-1), worin die zweite DSP-Stufe (200-2) Folgendes umfasst:
einen zweiten Voraddierer (1206), gekoppelt zum Empfangen des ersten Abgriffs vom ersten Register (1202) der ersten DSP-Stufe (200-1) an einem sechsten Register (1202) mit einer assoziierten Zwei-Zyklen-Verzögerung (z⁻²) und des Eingangssignals (1201) an einem siebten Register (1204) mit einer assoziierten Ein-Zyklus-Verzögerung (z⁻¹), sodass Eingaben vom sechsten Register (1202) und dem siebten Register (1204) am zweiten Voraddierer (1206) empfangen werden;
ein achtes Register (1208), an einen Ausgang des zweiten Voraddierers (1206) gekoppelt;
ein neuntes Register (1212), zum Empfangen des ersten gemeinsamen Koeffizienten (k₁) gekoppelt;
einen zweiten Multiplizierer (1210), an das achte Register (1208) und das neunte Register (1212) gekoppelt;
ein zehntes Register (1214), an einen Ausgang des zweiten Multiplizierers (1210) gekoppelt;
ein elftes Register (1218), zum Speichern einer Ausgabe der zweiten DSP-Stufe (200-2) gekoppelt; und
einen zweiten Addierer (1216), an das zehnte Register (1214) und den Ausgang der ersten DSP-Stufe (200-1) gekoppelt, worin ein Ausgang des zweiten Addierers (1216) an das elfte Register (1218) gekoppelt ist; und
eine dritte DSP-Stufe (200-3) zum Empfangen des Eingangssignals (1201), eines zweiten gemeinsamen Koeffizienten (k₀), eines zweiten Abgriffs, der mit dem zweiten gemeinsamen Koeffizienten (k₀) vom sechsten Register (1202) der zweiten DSP-Stufe (200-2) assoziiert ist, und einer Ausgabe der zweiten DSP-Stufe (200-2), worin die dritte DSP-Stufe (200-3) Folgendes umfasst:
einen dritten Voraddierer (1206), gekoppelt zum Empfangen des zweiten Abgriffs vom sechsten Register (1202) der zweiten DSP-Stufe (200-2) an einem zwölften Register (1202) mit einer assoziierten Zwei-Zyklen-Verzögerung (z⁻²) und des Eingangssignals an einem dreizehnten Register (1204) mit einer assoziierten Ein-Zyklus-Verzögerung (z⁻¹), sodass Eingaben vom zwölften Register (1202) und dem dreizehnten Register (1204) am dritten Voraddierer (1206) empfangen werden;
ein vierzehntes Register (1208), an einen Ausgang des dritten Voraddierers (1206) gekoppelt;
ein fünfzehntes Register (1212), zum Empfangen des zweiten gemeinsamen Koeffizienten (k₀) gekoppelt;
einen dritten Multiplizierer (1210), an das vierzehnte Register (1208) und das fünfzehnte Register (1212) gekoppelt;
ein sechzehntes Register (1214), an einen Ausgang des dritten Multiplizierers (1210) gekoppelt;
ein siebzehntes Register (1218) zum Speichern einer Ausgabe der dritten DSP-Stufe (200-3); und
einen dritten Addierer (1216), an das sechzehnte Register (1214) gekoppelt, um eine Ausgabe des dritten Multiplizierers (1210) zu der Ausgabe der zweiten DSP-Stufe (200-2) zu addieren, worin ein Ausgang des dritten Addierers (1216) an das siebzehnte Register (1218) gekoppelt ist.

2. Filter nach Anspruch 1, worin der erste Voraddierer eine Voraddiererschaltung umfasst, Folgendes umfassend:
einen Steuerbus (INMODE), an den ersten Voraddierer zur dynamischen Steueroperation des ersten Voraddierers gekoppelt;
einen ersten Eingangs-Port eines ersten Multiplexers (306), an den Steuerbus (INMODE) gekoppelt;
einen zweiten Eingangs-Port eines ersten Logikgatters (322), an den Steuerbus (INMODE) gekoppelt;
einen dritten Eingangs-Port eines zweiten Logikgatters (321), an den Steuerbus (INMODE) gekoppelt; und
einen vierten Eingangs-Port eines Addierers/Subtrahierers (331), an den Steuerbus (INMODE) gekoppelt.

3. Filter nach Anspruch 2, worin die erste Voraddiererschaltung dazu konfiguriert ist, einen fünften Dateneingangs-Port des Addierers/Subtrahierers dynamisch einzustellen, um einen Nullwert über den Ausgang des zweiten Logikgatters als Antwort auf die Eingabe vom vierten Eingangs-Port zu empfangen.

4. Filter nach Anspruch 3, worin die erste Voraddiererschaltung dazu konfiguriert ist, den vierten Dateneingangs-Port des Addierers/Subtrahierers dynamisch einzustellen, um den Nullwert über den Ausgang des zweiten Logikgatters als Antwort auf die Eingabe in den dritten Eingangs-Port zu empfangen.

5. Filter nach einem der Ansprüche 2-4, worin die erste Voraddiererschaltung dazu konfiguriert ist, Eingangsdaten entweder mit einer 0-, 1- oder 2-Registerverzögerung als Antwort auf Eingabe in den ersten Eingangs-Port dynamisch auszuwählen.

6. Filter nach einem der Ansprüche 2-4, worin die erste Voraddiererschaltung dazu konfiguriert ist, den Addierer/Subtrahierer entweder zum Addieren oder Subtrahieren als Antwort auf Eingabe in den vierten Eingangs-Port dynamisch einzustellen.

7. Verfahren zum Konfigurieren eines Filters in einer Schaltung, die in einer integrierten Schaltung implementiert ist und eine Vielzahl von DSP-Stufen (200-1, 200-2, 200-3) hat, worin jede DSP-Stufe (200-2, 200-3) nach einer ersten DSP-Stufe (200-1) zum Empfangen von Folgenden gekoppelt ist: ein Eingangssignal (1201), einen gemeinsamen Koeffizienten (k₁, k₀), einen Abgriff, der mit den gemeinsamen Koeffizienten (k₁, k₀) assoziiert ist, und eine Ausgabe der vorhergehenden DSP-Stufe, worin die erste DSP-Stufe (200-1) Folgendes umfasst:
einen Voraddierer (1206), gekoppelt zum Empfangen des Eingangssignals (1201) an einem ersten Register (1202) mit einer assoziierten Ein-Zyklus-Verzögerung (z⁻¹) und eine Null-Eingabe;
ein zweites Register (1208), an einen Ausgang des Voraddierers (1206) gekoppelt;
ein drittes Register (1212), zum Empfangen des ersten Koeffizienten (k₂) gekoppelt;
einen Multiplizierer (1210), an das zweite Register (1208) und das dritte Register (1212) gekoppelt;
ein viertes Register (1214), an einen Ausgang des ersten Multiplizierers (1210) gekoppelt;
ein fünftes Register (1218) zum Speichern einer Ausgabe der ersten DSP-Stufe (200-1); und
einen Addierer (1216), an das vierte Register (1214) und eine Null-Eingabe gekoppelt, worin ein Ausgang des ersten Addierers (1216) an das fünfte Register (1218) gekoppelt ist; und
worin jede DSP-Stufe (200-2, 200-3) nach der ersten DSP-Stufe (200-1) Folgendes umfasst:
einen Voraddierer (1206), gekoppelt zum Empfangen eines Abgriffs vom ersten Register (1202) der vorhergehenden DSP-Stufe an einem sechsten Register (1202) mit einer assoziierten Zwei-Zyklen-Verzögerung (z⁻²) und des Eingangssignals an einem siebten Register (1204) mit einer assoziierten Ein-Zyklus-Verzögerung (z⁻¹), sodass Eingaben vom sechsten Register (1202) und dem siebten Register (1204) am zweiten Voraddierer (1206) empfangen werden;
ein achtes Register (1208), an einen Ausgang des Voraddierers (1206) gekoppelt;
ein neuntes Register (1212), zum Empfangen des gemeinsamen Koeffizienten (k₁, k₀) gekoppelt;
einen Multiplizierer (1210), an das achte Register (1208) und das neunte Register (1212) gekoppelt;
ein zehntes Register (1214), an einen Ausgang des Multiplizierers (1210) gekoppelt;
ein elftes Register (1218) zum Speichern einer Ausgabe der DSP-Stufe (200-2, 200-3); und
einen Addierer (1216), an das zehnte Register (1214) und den Ausgang der vorhergehenden DSP-Stufe gekoppelt, worin ein Ausgang des Addierers (1216) an das elfte Register (1218) gekoppelt ist;
wobei das Verfahren Folgendes umfasst:
Empfangen eines High-Level-Designs der Schaltung;
Identifizieren eines Filters im High-Level-Design;
Analysieren von Koeffizienten des Filters;
Transformieren des Filters des High-Level-Designs in ein symmetrisches transponiertes Faltungs-FIR-Filter, in der integrierten Schaltung unter Verwendung der Vielzahl von DSP-Stufen implementiert, worin jede DSP-Stufe der Vielzahl von DSP-Stufen nach der ersten DSP-Stufe dazu konfiguriert ist, den mit der DSP-Stufe assoziierten gemeinsamen Koeffizienten anzupassen, und worin das Filter das Eingangssignal der ersten DSP-Stufe empfängt und jede DSP-Stufe nach der ersten DSP-Stufe zum Empfangen eines Abgriffs gekoppelt ist, der mit dem gemeinsamen Koeffizienten der DSP-Stufe assoziiert ist.

8. Verfahren nach Anspruch 7, außerdem umfassend, dass für jede DSP-Stufe nach der ersten DSP-Stufe der gemeinsame Koeffizient als eine erste Eingabe in den Multiplizierer (1210) der DSP-Stufe bereitgestellt wird.

9. Verfahren nach Anspruch 8, außerdem umfassend, dass für jede DSP-Stufe nach der ersten DSP-Stufe eine Summe von Abgriffen bereitgestellt wird, die mit dem gemeinsamen Koeffizienten als eine zweite Eingabe in den Multiplizierer assoziiert ist.

10. Verfahren nach Anspruch 9, worin das Bereitstellen der Summe der Abgriffe, die mit dem gemeinsamen Koeffizienten assoziiert sind, als eine zweite Eingabe in den Multiplizierer das Erzeugen der Summe unter Verwendung der Voraddiererschaltung (1206) des DSP-Blocks umfasst.

11. Verfahren nach Anspruch 8, außerdem umfassend, dass für jede DSP-Stufe nach der ersten DSP-Stufe eine Differenz von Abgriffen, die mit dem gemeinsamen Koeffizienten assoziiert sind, als eine zweite Eingabe in den Multiplizierer bereitgestellt wird.

12. Symmetrisches transponiertes Faltungs-FIR-Filter einer integrierten Schaltung, Folgendes umfassend:
ein Eingangssignal;
eine erste DSP-Stufe (200-1) zum Empfangen des Eingangssignals (1201) und eines ersten gemeinsamen Koeffizienten (k₂), worin die erste DSP-Stufe (200-1) Folgendes umfasst:
einen ersten Voraddierer (1206), gekoppelt zum Empfangen des Eingangssignals (1201) an einem ersten Register (1202) mit einer assoziierten Zwei-Zyklen-Verzögerung (z⁻²) und an einem zweiten Register (1204) mit einer assoziierten Ein-Zyklus-Verzögerung (z⁻¹), sodass Eingaben vom ersten Register (1202) und dem zweiten Register (1204) am ersten Voraddierer (1206) empfangen werden;
ein drittes Register (1208), an einen Ausgang des ersten Voraddierers (1206) gekoppelt;
ein viertes Register (1212), zum Empfangen des ersten gemeinsamen Koeffizienten (k₂) gekoppelt;
einen ersten Multiplizierer (1210), an das dritte Register (1208) und das vierte Register (1212) gekoppelt;
ein fünftes Register (1214), an einen Ausgang des ersten Multiplizierers (1210) gekoppelt;
ein sechstes Register (1218) zum Speichern einer Ausgabe der ersten DSP-Stufe (200-1) gekoppelt; und
einen ersten Addierer (1216), an das fünfte Register (1214) und eine Null-Eingabe gekoppelt, worin ein Ausgang des ersten Addierers (1216) an das sechste Register (1218) gekoppelt ist; und
eine zweite DSP-Stufe (200-2) zum Empfangen des Eingangssignals (1201), eines zweiten gemeinsamen Koeffizienten (k₁), eines ersten Abgriffs, assoziiert mit dem zweiten gemeinsamen Koeffizienten (k₁) vom ersten Register (1202) der ersten DSP-Stufe (200-1), und einer Ausgabe der ersten DSP-Stufe (200-1), worin die zweite DSP-Stufe (200-1) Folgendes umfasst:
einen zweiten Voraddierer (1206), gekoppelt zum Empfangen des ersten Abgriffs vom ersten Register (1202) der ersten DSP-Stufe (200-1) an einem siebten Register (1202) mit einer assoziierten Zwei-Zyklen-Verzögerung (z⁻²) und des Eingangssignals (1201) an einem achten Register (1204) mit einer assoziierten Ein-Zyklus-Verzögerung (z⁻¹), sodass Eingaben vom sechsten Register (1202) und dem siebten Register (1204) am zweiten Voraddierer (1206) empfangen werden;
ein neuntes Register (1208), an einen Ausgang des zweiten Voraddierers (1206) gekoppelt;
ein zehntes Register (1212), zum Empfangen des zweiten gemeinsamen Koeffizienten (k₁) gekoppelt;
einen zweiten Multiplizierer (1210), an das neunte Register (1208) und das zehnte Register (1212) gekoppelt;
ein elftes Register (1214), an einen Ausgang des zweiten Multiplizierers (1210) gekoppelt;
ein zwölftes Register (1218), zum Speichern einer Ausgabe der zweiten DSP-Stufe (200-2) gekoppelt; und
einen zweiten Addierer (1216), an das elfte Register (1214) und den Ausgang der ersten DSP-Stufe (200-1) gekoppelt, worin ein Ausgang des zweiten Addierers (1216) an das zwölfte Register (1218) gekoppelt ist; und
eine dritte DSP-Stufe (200-3) zum Empfangen des Eingangssignals (1201), eines dritten gemeinsamen Koeffizienten (k₀), eines zweiten Abgriffs, der mit dem dritten gemeinsamen Koeffizienten (k₀) vom siebten Register (1202) der zweiten DSP-Stufe (200-2) assoziiert ist, und einer Ausgabe der zweiten DSP-Stufe (200-2), worin die dritte DSP-Stufe (200-3) Folgendes umfasst:
einen dritten Voraddierer (1206), gekoppelt zum Empfangen des zweiten Abgriffs vom siebten Register (1202) der zweiten DSP-Stufe (200-2) an einem dreizehnten Register (1202) mit einer assoziierten Zwei-Zyklen-Verzögerung (z⁻²) und des Eingangssignals an einem vierzehnten Register (1204) mit einer assoziierten Ein-Zyklus-Verzögerung (z⁻¹), sodass Eingaben vom zwölften Register (1202) und dem dreizehnten Register (1204) am dritten Voraddierer (1206) empfangen werden;
ein fünfzehntes Register (1208), an einen Ausgang des dritten Voraddierers (1206) gekoppelt;
ein sechzehntes Register (1212), zum Empfangen des dritten gemeinsamen Koeffizienten (k₀) gekoppelt;
einen dritten Multiplizierer (1210), an das fünfzehnte Register (1208) und das sechzehnte Register (1212) gekoppelt;
ein siebzehntes Register (1214), an einen Ausgang des dritten Multiplizierers (1210) gekoppelt;
ein achtzehntes Register (1218) zum Speichern einer Ausgabe der dritten DSP-Stufe (200-3); und
einen dritten Addierer (1216), gekoppelt an das siebzehnte Register (1214), zum Addieren einer Ausgabe des dritten Multiplizierers (1210) zu der Ausgabe der zweiten DSP-Stufe (200-2), worin ein Ausgang des dritten Addierers (1216) an das achtzehnte Register (1218) gekoppelt ist.

13. Symmetrisches transponiertes Faltungs-FIR-Filter einer integrierten Schaltung, Folgendes umfassend:
ein Eingangssignal (1201);
eine erste DSP-Stufe (200-1) zum Empfangen des Eingangssignals (1201) und eines ersten gemeinsamen Koeffizienten (k₂/2), worin die erste DSP-Stufe (200-1) Folgendes umfasst:
einen ersten Voraddierer (1206), gekoppelt zum Empfangen des Eingangssignals (1201) an einem ersten Register (1202) mit einer assoziierten Ein-Zyklus-Verzögerung und an einem zweiten Register (1204) mit einer assoziierten Ein-Zyklus-Verzögerung, sodass dieselben Eingaben vom ersten Register (1202) und vom zweiten Register (1204) am ersten Voraddierer (1206) empfangen werden;
ein drittes Register (1208), an einen Ausgang des ersten Voraddierers (1206) gekoppelt;
ein viertes Register (1212), zum Empfangen des ersten gemeinsamen Koeffizienten (k2/2) gekoppelt;
einen ersten Multiplizierer (1210), an das dritte Register (1208) und das vierte Register (1212) gekoppelt;
ein fünftes Register (1214), an einen Ausgang des ersten Multiplizierers (1210) gekoppelt;
ein sechstes Register (1218) zum Speichern einer Ausgabe der ersten DSP-Stufe (200-1) gekoppelt; und
einen ersten Addierer (1216), an das fünfte Register (1214) und eine Null-Eingabe gekoppelt, worin ein Ausgang des ersten Addierers (1216) an das sechste Register (1218) gekoppelt ist; und
eine zweite DSP-Stufe (200-2) zum Empfangen des Eingangssignals (1201), eines zweiten gemeinsamen Koeffizienten (k₁), eines ersten Abgriffs, mit dem zweiten gemeinsamen Koeffizienten (k₁) vom ersten Register (1202) der ersten DSP-Stufe (200-1) assoziiert, und einer Ausgabe der ersten DSP-Stufe (200-1), worin die zweite DSP-Stufe (200-2) Folgendes umfasst:
einen zweiten Voraddierer (1206), gekoppelt zum Empfangen des ersten Abgriffs vom ersten Register (1202) der ersten DSP-Stufe (200-1) an einem siebten Register (1202) mit einer assoziierten Zwei-Zyklen-Verzögerung (z⁻²) und des Eingangssignals an einem achten Register (1204) mit einer assoziierten Ein-Zyklus-Verzögerung (z⁻¹), sodass Eingaben vom sechsten Register (1202) und dem siebten Register (1204) am zweiten Voraddierer (1206) empfangen werden;
ein neuntes Register (1208), an den Ausgang des zweiten Voraddierers (1206) gekoppelt;
ein zehntes Register (1212), zum Empfangen des zweiten gemeinsamen Koeffizienten (k₁) gekoppelt;
einen zweiten Multiplizierer (1210), an das neunte Register (1208) und das zehnte Register (1212) gekoppelt;
ein elftes Register (1214), an einen Ausgang des zweiten Multiplizierers (1210) gekoppelt;
ein zwölftes Register (1218), zum Speichern einer Ausgabe der zweiten Stufe (200-2) gekoppelt; und
einen zweiten Addierer (1216), an das elfte Register (1214) und den Ausgang der ersten DSP-Stufe (200-1) gekoppelt, worin ein Ausgang des zweiten Addierers (1216) an das zwölfte Register (1218) gekoppelt ist; und
eine dritte DSP-Stufe (200-3) zum Empfangen des Eingangssignals (1201), eines dritten gemeinsamen Koeffizienten (k₀), eines zweiten Abgriffs, der mit dem dritten gemeinsamen Koeffizienten (k₀) vom siebten Register (1202) der zweiten DSP-Stufe (200-2) assoziiert ist, und einer Ausgabe der zweiten DSP-Stufe (200-2), worin die dritte DSP-Stufe (200-3) Folgendes umfasst:
einen dritten Voraddierer (1206), gekoppelt an den zweiten Abgriff vom siebten Register (1202) der zweiten DSP-Stufe (200-2) an einem dreizehnten Register (1202) mit einer assoziierten Zwei-Zyklen-Verzögerung (z⁻²) und dem Eingangssignal an einem vierzehnten Register (1204) mit einer assoziierten Ein-Zyklus-Verzögerung (z⁻¹), sodass Eingaben vom zwölften Register (1202) und dem dreizehnten Register (1204) am dritten Voraddierer (1206) empfangen werden;
ein fünfzehntes Register (1208), an einen Ausgang des dritten Voraddierers (1206) gekoppelt;
ein sechzehntes Register (1212), zum Empfangen des dritten gemeinsamen Koeffizienten (k₀) gekoppelt;
einen dritten Multiplizierer (1210), an das fünfzehnte Register (1208) und das sechzehnte Register (1212) gekoppelt;
ein siebzehntes Register (1214), an einen Ausgang des dritten Multiplizierers (1210) gekoppelt;
ein achtzehntes Register (1218) zum Speichern einer Ausgabe der dritten DSP-Stufe (200-3); und
einen dritten Addierer (1216), an das siebzehnte Register (1214) zum Addieren einer Ausgabe des dritten Multiplizierers (1210) zu der Ausgabe der zweiten DSP-Stufe (200-2) gekoppelt, worin ein Ausgang des dritten Addierers (1216) an das achtzehnte Register (1218) gekoppelt ist.

## Revendications

1. Filtre de convolution à réponse impulsionnelle finie, FIR, de forme transposée symétrique d'un circuit intégré, comportant :
un signal d'entrée ;
un premier étage de traitement DSP (200-1) destiné à recevoir le signal d'entrée (1201) et un premier coefficient (k₂), dans lequel le premier étage de traitement DSP (200-1) comporte :
un premier pré-additionneur (1206) couplé de manière à recevoir le signal d'entrée (1201) au niveau d'un premier registre (1202) avec un retard d'un cycle associé (z⁻¹) et une entrée nulle ;
un deuxième registre (1208) couplé à une sortie du premier pré-additionneur (1206) ;
un troisième registre (1212) couplé de manière à recevoir le premier coefficient (k₂) ;
un premier multiplicateur (1210) couplé au deuxième registre (1208) et au troisième registre (1212) ;
un quatrième registre (1214) couplé à une sortie du premier multiplicateur (1210) ;
un cinquième registre (1218) couplé de manière à stocker une sortie du premier étage de traitement DSP (200-1) ; et
un premier additionneur (1216) couplé au quatrième registre (1214) et à une entrée nulle, dans lequel une sortie du premier additionneur (1216) est couplée au cinquième registre (1218) ; et
un deuxième étage de traitement DSP (200-2) destiné à recevoir le signal d'entrée (1201), un premier coefficient commun (k₁), une première prise associée au premier coefficient commun (k₁) en provenance du premier registre (1202) du premier étage de traitement DSP (200-1), et la sortie du premier étage de traitement DSP (200-1), dans lequel le deuxième étage de traitement DSP (200-2) comporte :
un deuxième pré-additionneur (1206) couplé de manière à recevoir la première prise en provenance du premier registre (1202) du premier étage de traitement DSP (200-1) au niveau d'un sixième registre (1202) avec un retard de deux cycles associé (z⁻²), et le signal d'entrée (1201) au niveau d'un septième registre (1204) avec un retard d'un cycle associé (z⁻¹), de sorte que des entrées sont reçues en provenance du sixième registre (1202) et du septième registre (1204) au niveau du deuxième pré-additionneur (1206) ;
un huitième registre (1208) couplé à une sortie du deuxième pré-additionneur (1206) ;
un neuvième registre (1212) couplé de manière à recevoir le premier coefficient commun (k₁) ;
un deuxième multiplicateur (1210) couplé au huitième registre (1208) et au neuvième registre (1212) ;
un dixième registre (1214) couplé à une sortie du deuxième multiplicateur (1210) ;
un onzième registre (1218) couplé de manière à stocker une sortie du deuxième étage de traitement DSP (200-2) ; et
un deuxième additionneur (1216) couplé au dixième registre (1214) et à la sortie du premier étage de traitement DSP (200-1), dans lequel une sortie du deuxième additionneur (1216) est couplée au onzième registre (1218) ; et
un troisième étage de traitement DSP (200-3) destiné à recevoir le signal d'entrée (1201), un deuxième coefficient commun (k₀), une seconde prise associée au deuxième coefficient commun (k₀) en provenance du sixième registre (1202) du deuxième étage de traitement DSP (200-2), et une sortie du deuxième étage de traitement DSP (200-2), dans lequel le troisième étage de traitement DSP (200-3) comporte :
un troisième pré-additionneur (1206) couplé de manière à recevoir la seconde prise en provenance du sixième registre (1202) du deuxième étage de traitement DSP (200-2) au niveau d'un douzième registre (1202) avec un retard de deux cycles associé (z⁻²), et le signal d'entrée au niveau d'un treizième registre (1204) avec un retard d'un cycle associé (z⁻¹), de sorte que des entrées sont reçues en provenance du douzième registre (1202) et du treizième registre (1204) au niveau du troisième pré-additionneur (1206) ;
un quatorzième registre (1208) couplé à une sortie du troisième pré-additionneur (1206) ;
un quinzième registre (1212) couplé de manière à recevoir le deuxième coefficient commun (k₀) ;
un troisième multiplicateur (1210) couplé au quatorzième registre (1208) et au quinzième registre (1212) ;
un seizième registre (1214) couplé à une sortie du troisième multiplicateur (1210) ;
un dix-septième registre (1218) destiné à stocker une sortie du troisième étage de traitement DSP (200-3) ; et
un troisième additionneur (1216), couplé au seizième registre (1214), destiné à ajouter une sortie du troisième multiplicateur (1210) à la sortie du deuxième étage de traitement DSP (200-2), dans lequel une sortie du troisième additionneur (1216) est couplée au dix-septième registre (1218).

2. Filtre selon la revendication 1, dans lequel le premier pré-additionneur comporte un circuit de pré-additionneur comportant :
un bus de commande (INMODE) couplé au premier pré-additionneur en vue de commander de manière dynamique le fonctionnement du premier pré-additionneur ;
un premier port d'entrée d'un premier multiplexeur (306) couplé au bus de commande (INMODE) ;
un deuxième port d'entrée d'une première porte logique (322) couplé au bus de commande (INMODE) ;
un troisième port d'entrée d'une deuxième porte logique (321) couplé au bus de commande (INMODE) ; et
un quatrième port d'entrée d'un additionneur/soustracteur (331) couplé au bus de commande (INMODE).

3. Filtre selon la revendication 2, dans lequel le premier circuit de pré-additionneur est configuré de manière à définir dynamiquement un cinquième port d'entrée de données de l'additionneur/soustracteur en vue de recevoir une valeur de zéro par l'intermédiaire de la sortie de la deuxième porte logique en réponse à une entrée en provenance du quatrième port d'entrée.

4. Filtre selon la revendication 3, dans lequel le premier circuit de pré-additionneur est configuré de manière à définir dynamiquement le quatrième port d'entrée de données de l'additionneur/soustracteur en vue de recevoir la valeur de zéro par l'intermédiaire de la sortie de la deuxième porte logique, en réponse à une entrée au niveau du troisième port d'entrée.

5. Filtre selon l'une quelconque des revendications 2 à 4, dans lequel le premier circuit de pré-additionneur est configuré de manière à sélectionner dynamiquement des données d'entrée présentant soit un retard de 0, 1, ou 2 cycles de registre, en réponse à une entrée au niveau du premier port d'entrée.

6. Filtre selon l'une quelconque des revendications 2 à 4, dans lequel le premier circuit de pré-additionneur est configuré de manière à définir dynamiquement l'additionneur/soustracteur à des fins d'addition ou de soustraction en réponse à une entrée au niveau du quatrième port d'entrée.

7. Procédé de configuration d'un filtre dans un circuit mis en oeuvre dans un circuit intégré et présentant une pluralité d'étages de traitement DSP (200-1, 200-2, 200-3), dans lequel chaque étage de traitement DSP (200-2, 200-3), après un premier étage de traitement DSP (200-1), est couplé de manière à recevoir un signal d'entrée (1201), un coefficient commun (k₁, k₀), une prise associée au coefficient commun (k₁, k₀), et une sortie de l'étage de traitement DSP précédent, dans lequel le premier étage de traitement DSP (200-1) comporte:
un premier pré-additionneur (1206) couplé de manière à recevoir le signal d'entrée (1201) au niveau d'un premier registre (1202) avec un retard d'un cycle associé (z⁻¹) et une entrée nulle ;
un deuxième registre (1208) couplé à une sortie du premier pré-additionneur (1206) ;
un troisième registre (1212) couplé de manière à recevoir le premier coefficient (k₂) ;
un multiplicateur (1210) couplé au deuxième registre (1208) et au troisième registre (1212) ;
un quatrième registre (1214) couplé à une sortie du premier multiplicateur (1210) ;
un cinquième registre (1218) couplé de manière à stocker une sortie du premier étage de traitement DSP (200-1) ; et
un additionneur (1216) couplé au quatrième registre (1214) et à une entrée nulle, dans lequel une sortie de l'additionneur (1216) est couplée au cinquième registre (1218) ; et
dans lequel chaque étage de traitement DSP (200-2, 200-3) après un premier étage de traitement DSP (200-1) comporte :
un pré-additionneur (1206) couplé de manière à recevoir une prise en provenance du premier registre (1202) de l'étage de traitement DSP précédent au niveau d'un sixième registre (1202) avec un retard de deux cycles associé (z⁻²), et le signal d'entrée au niveau d'un septième registre (1204) avec un retard d'un cycle associé (z⁻¹), de sorte que des entrées sont reçues en provenance du sixième registre (1202) et du septième registre (1204) au niveau du deuxième pré-additionneur (1206) ;
un huitième registre (1208) couplé à une sortie du pré-additionneur (1206) ;
un neuvième registre (1212) couplé de manière à recevoir le premier coefficient commun (k₁, k₀) ;
un multiplicateur (1210) couplé au huitième registre (1208) et au neuvième registre (1212) ;
un dixième registre (1214) couplé à une sortie du multiplicateur (1210) ;
un onzième registre (1218) destiné à stocker une sortie de l'étage de traitement DSP (200-2, 200-3) ; et
un additionneur (1216) couplé au dixième registre (1214) et à la sortie de l'étage de traitement DSP précédent, dans lequel une sortie de l'additionneur (1216) est couplée au onzième registre (1218) ;
le procédé comportant les étapes ci-dessous consistant à :
recevoir une conception de haut niveau du circuit ;
identifier un filtre dans la conception de haut niveau ;
analyser des coefficients du filtre ;
transformer le filtre de la conception de haut niveau en un filtre de convolution à réponse impulsionnelle finie, FIR, de forme transposée symétrique, mis en oeuvre dans le circuit intégré, en utilisant la pluralité d'étages de traitement DSP, dans lequel chaque étage de traitement DSP de la pluralité d'étages de traitement DSP après le premier étage de traitement DSP est configuré de manière à accueillir le coefficient commun associé à l'étage de traitement DSP, et dans lequel le filtre reçoit le signal d'entrée au niveau du premier étage de traitement DSP, et chaque étage de traitement DSP, après le premier étage de traitement DSP, est couplé de manière à recevoir une prise associée au coefficient commun pour l'étage de traitement DSP.

8. Procédé selon la revendication 7, comportant en outre, pour chaque étage de traitement DSP après le premier étage de traitement DSP, l'étape consistant à fournir le coefficient commun sous la forme d'une première entrée au niveau du multiplicateur (1210) de l'étage de traitement DSP.

9. Procédé selon la revendication 8, comportant en outre, pour chaque étage de traitement DSP, après le premier étage de traitement DSP, l'étape consistant à fournir une somme de prises associées au coefficient commun sous la forme d'une deuxième entrée au niveau du multiplicateur.

10. Procédé selon la revendication 9, dans lequel l'étape consistant à fournir la somme des prises associées au coefficient commun sous la forme d'une deuxième entrée au niveau du multiplicateur, comporte l'étape consistant à générer la somme en utilisant le circuit de pré-additionneur (1206) du bloc de traitement DSP.

11. Procédé selon la revendication 8, comportant en outre, pour chaque étage de traitement DSP, après le premier étage de traitement DSP, l'étape consistant à fournir une différence de prises associées au coefficient commun sous la forme d'une deuxième entrée au niveau du multiplicateur.

12. Filtre de convolution à réponse impulsionnelle finie, FIR, de forme transposée symétrique d'un circuit intégré, comportant :
un signal d'entrée ;
un premier étage de traitement DSP (200-1) destiné à recevoir le signal d'entrée (1201) et un premier coefficient commun (k₂), dans lequel le premier étage de traitement DSP (200-1) comporte:
un premier pré-additionneur (1206) couplé de manière à recevoir le signal d'entrée (1201) au niveau d'un premier registre (1202), avec un retard de deux cycles associé (z⁻²), et au niveau d'un deuxième registre (1204), avec un retard d'un cycle associé (z⁻¹), de sorte que des entrées sont reçues en provenance du premier registre (1202) et du deuxième registre (1204) au niveau du premier pré-additionneur (1206) ;
un troisième registre (1208) couplé à une sortie du premier pré-additionneur (1206) ;
un quatrième registre (1212) couplé de manière à recevoir le premier coefficient commun (k₂) ;
un premier multiplicateur (1210) couplé au troisième registre (1208) et au quatrième registre (1212) ;
un cinquième registre (1214) couplé à une sortie du premier multiplicateur (1210)
un sixième registre (1218) couplé de manière à stocker une sortie du premier étage de traitement DSP (200-1) ; et
un premier additionneur (1216) couplé au cinquième registre (1214) et à une entrée nulle, dans lequel une sortie du premier additionneur (1216) est couplée au sixième registre (1218) ; et
un deuxième étage de traitement DSP (200-2) destiné à recevoir le signal d'entrée (1201), un deuxième coefficient commun (k₁), une première prise associée au deuxième coefficient commun (k₁) en provenance du premier registre (1202) du premier étage de traitement DSP (200-1), et une sortie du premier étage de traitement DSP (200-1), dans lequel le deuxième étage de traitement DSP (200-1) comporte :
un deuxième pré-additionneur (1206) couplé de manière à recevoir la première prise en provenance du premier registre (1202) du premier étage de traitement DSP (200-1) au niveau d'un septième registre (1202), avec un retard de deux cycles associé (z⁻²), et le signal d'entrée (1201) au niveau d'un huitième registre (1204), avec un retard d'un cycle associé (z⁻¹), de sorte que des entrées sont reçues en provenance du sixième registre (1202) et du septième registre (1204) au niveau du deuxième pré-additionneur (1206) ;
un neuvième registre (1208) couplé à une sortie du deuxième pré-additionneur (1206) ;
un dixième registre (1212) couplé de manière à recevoir le deuxième coefficient commun (k₁) ;
un deuxième multiplicateur (1210) couplé au neuvième registre (1208) et au dixième registre (1212) ;
un onzième registre (1214) couplé à une sortie du deuxième multiplicateur (1210) ;
un douzième registre (1218) destiné à stocker une sortie du deuxième étage de traitement DSP (200-2) ; et
un deuxième additionneur (1216) couplé au onzième registre (1214) et à la sortie du premier étage de traitement DSP (200-1), dans lequel une sortie du deuxième additionneur (1216) est couplée au douzième registre (1218) ; et
un troisième étage de traitement DSP (200-3) destiné à recevoir le signal d'entrée (1201), un troisième coefficient commun (k₀), une seconde prise associée au troisième coefficient commun (k₀) en provenance du septième registre (1202) du deuxième étage de traitement DSP (200-2), et une sortie du deuxième étage de traitement DSP (200-2), dans lequel le troisième étage de traitement DSP (200-3) comporte :
un troisième pré-additionneur (1206) couplé à la seconde prise en provenance du septième registre (1202) du deuxième étage de traitement DSP (200-2) au niveau d'un treizième registre (1202), avec un retard de deux cycles associé (z⁻²), et au signal d'entrée au niveau d'un quatorzième registre (1204), avec un retard d'un cycle associé (z⁻¹), de sorte que des entrées sont reçues en provenance du douzième registre (1202) et du treizième registre (1204) au niveau du troisième pré-additionneur (1206) ;
un quinzième registre (1208) couplé à une sortie du troisième pré-additionneur (1206) ;
un seizième registre (1212) couplé de manière à recevoir le troisième coefficient commun (k₀) ;
un troisième multiplicateur (1210) couplé au quinzième registre (1208) et au seizième registre (1212) ;
un dix-septième registre (1214) couplé à une sortie du troisième multiplicateur (1210) ;
un dix-huitième registre (1218) destiné à stocker une sortie du troisième étage de traitement DSP (200-3) ; et
un troisième additionneur (1216), couplé au dix-septième registre (1214), destiné à ajouter une sortie du troisième multiplicateur (1210) à la sortie du deuxième étage de traitement DSP (200-2), dans lequel une sortie du troisième additionneur (1216) est couplée au dix-huitième registre (1218).

13. Filtre de convolution à réponse impulsionnelle finie, FIR, de forme transposée symétrique d'un circuit intégré, comportant :
un signal d'entrée (1201) ;
un premier étage de traitement DSP (200-1) destiné à recevoir le signal d'entrée (1201) et un premier coefficient commun (k₂/2), dans lequel le premier étage de traitement DSP (200-1) comporte :
un premier pré-additionneur (1206) couplé de manière à recevoir le signal d'entrée (1201) au niveau d'un premier registre (1202), avec un retard d'un cycle associé, et au niveau d'un deuxième registre (1204), avec un retard d'un cycle associé, de sorte que les mêmes entrées sont reçues en provenance du premier registre (1202) et du deuxième registre (1204) au niveau du premier pré-additionneur (1206) ;
un troisième registre (1208) couplé à une sortie du premier pré-additionneur (1206) ;
un quatrième registre (1212) couplé de manière à recevoir le premier coefficient commun (k₂/2);
un premier multiplicateur (1210) couplé au troisième registre (1208) et au quatrième registre (1212) ;
un cinquième registre (1214) couplé à une sortie du premier multiplicateur (1210)
un sixième registre (1218) couplé de manière à stocker une sortie du premier étage de traitement DSP (200-1) ; et
un premier additionneur (1216) couplé au cinquième registre (1214) et à une entrée nulle, dans lequel une sortie du premier additionneur (1216) est couplée au sixième registre (1218) ; et
un deuxième étage de traitement DSP (200-2) destiné à recevoir le signal d'entrée (1201), un deuxième coefficient commun (k₁), une première prise associée au deuxième coefficient commun (k₁) en provenance du premier registre (1202) du premier étage de traitement DSP (200-1), et une sortie du premier étage de traitement DSP (200-1), dans lequel le deuxième étage de traitement DSP (200-1) comporte :
un deuxième pré-additionneur (1206) couplé de manière à recevoir la première prise en provenance du premier registre (1202) du premier étage de traitement DSP (200-1) au niveau d'un septième registre (1202), avec un retard de deux cycles associé (z⁻²), et le signal d'entrée au niveau d'un huitième registre (1204), avec un retard d'un cycle associé (z⁻¹), de sorte que des entrées sont reçues en provenance du sixième registre (1202) et du septième registre (1204) au niveau du deuxième pré-additionneur (1206) ;
un neuvième registre (1208) couplé à une sortie du deuxième pré-additionneur (1206) ;
un dixième registre (1212) couplé de manière à recevoir le deuxième coefficient commun (k₁) ;
un deuxième multiplicateur (1210) couplé au neuvième registre (1208) et au dixième registre (1212) ;
un onzième registre (1214) couplé à une sortie du deuxième multiplicateur (1210) ;
un douzième registre (1218) destiné à stocker une sortie du deuxième étage de traitement DSP (200-2) ; et
un deuxième additionneur (1216) couplé au onzième registre (1214) et à la sortie du premier étage de traitement DSP (200-1), dans lequel une sortie du deuxième additionneur (1216) est couplée au douzième registre (1218) ; et
un troisième étage de traitement DSP (200-3) destiné à recevoir le signal d'entrée (1201), un troisième coefficient commun (k₀), une seconde prise associée au troisième coefficient commun (k₀) en provenance du septième registre (1202) du deuxième étage de traitement DSP (200-2), et une sortie du deuxième étage de traitement DSP (200-2), dans lequel le troisième étage de traitement DSP (200-3) comporte :
un troisième pré-additionneur (1206) couplé à la seconde prise en provenance du septième registre (1202) du deuxième étage de traitement DSP (200-2) au niveau d'un treizième registre (1202), avec un retard de deux cycles associé (z⁻²), et au signal d'entrée (1201) au niveau d'un quatorzième registre (1204), avec un retard d'un cycle associé (z⁻¹), de sorte que des entrées sont reçues en provenance du douzième registre (1202) et du treizième registre (1204) au niveau du troisième pré-additionneur (1206) ;
un quinzième registre (1208) couplé à une sortie du troisième pré-additionneur (1206) ;
un seizième registre (1212) couplé de manière à recevoir le troisième coefficient commun (k₀) ;
un troisième multiplicateur (1210) couplé au quinzième registre (1208) et au seizième registre (1212) ;
un dix-septième registre (1214) couplé à une sortie du troisième multiplicateur (1210) ;
un dix-huitième registre (1218) destiné à stocker une sortie du troisième étage de traitement DSP (200-3) ; et
un troisième additionneur (1216), couplé au dix-septième registre (1214), destiné à ajouter une sortie du troisième multiplicateur (1210) à la sortie du deuxième étage de traitement DSP (200-2), dans lequel une sortie du troisième additionneur (1216) est couplée au dix-huitième registre (1218).
